# EUROPEAN PATENT APPLICATION

(11) **EP 4 629 785 A1**
(43) Date of publication of application: **08.10.2025**
(21) Application number: 25167974.2
(22) Date of filing: 02.04.2025
(51) Int. Cl.: H10F 39/18, H10F 39/00

(54) **IMAGE SENSOR**

(30) Priority: 03.04.2024 KR 20240045486
(71) Applicant: SAMSUNG ELECTRONICS CO., LTD., Yeongtong-gu Suwon-si, Gyeonggi-do 16677 (KR)
(72) Inventor: LEE, Haewon, 16677 Suwon-si, Gyeonggi-do (KR)
(74) Representative: Kuhnen & Wacker Patent- und Rechtsanwaltsbüro PartG mbB

(57) **Abstract**

An image sensor may include a first pixel (PX1-PX8) configured to detect a first color, a second pixel (PX1-PX8) configured to detect a second color different from the first color, a first active region (AR) located in the first pixel (PX1-PX8), and a second active region (AR) located in the second pixel, where the first active region (AR) and the second active region (AR) are directly connected to each other.

## Description

### BACKGROUND

### 1. Field

The present disclosure relates to an image sensor.

### 2. Description of the Related Art

An image sensor is a semiconductor device that converts optical images into electrical signals. Image sensors can be classified into charge-coupled device (CCD) and complementary metal-oxide semiconductor (CMOS).

Compared to CCD image sensors with high-voltage analog circuits, a CMOS image sensor (CIS) has the advantage of lower manufacturing cost and lower power consumption due to the small device size, and is widely used in home appliances as well as in portable devices such as smartphones and digital cameras.

The pixel array that constitutes the CMOS image sensor includes a photoelectric conversion portion such as a photodiode for each pixel. The photoelectric conversion portion may generate an electrical signal that varies depending on the amount of incident light, and the CMOS image sensor may synthesize an image by processing the electrical signal.

A CMOS image sensor may include a plurality of transistors for driving a photoelectric conversion portion.

Recently, in response to the demand for high-resolution images, the pixel size of the image sensor is becoming smaller and the number of pixels is increasing. Therefore, fast operation characteristics of transistors within the image sensor are generally required.

### SUMMARY

The present disclosure describes an image sensor capable of maintaining fast operation characteristics.

However, the issues addressed by embodiments are not limited to the above-described issues and may be variously extended in a range of technical ideas included in various embodiments.

An image sensor may include a first pixel configured to detect a first color, a second pixel configured to detect a second color different from the first color, a first active region located in the first pixel, and a second active region located in the second pixel, where the first active region and the second active region are directly connected to each other.

An image sensor may include a first pixel group configured to detect a first color, and including a plurality of pixels including a first pixel, and a second pixel group configured to detect a second color different from the first color, and including a plurality of pixels including a second pixel adjacent to the first pixel group, where the first pixel group and the second pixel group share a reset transistor, a source follower transistor, and a selection transistor, where the source follower transistor may include a first source follower transistor located in the first pixel and a second source follower transistor located in the second pixel, and where the first source follower transistor and the second source follower transistor are directly connected.

According to an embodiment, an image sensor capable of maintaining fast operation characteristics may be provided.

The effects of the embodiments are not limited to the above-described effect, and may be variously extended without departing from the spirit and scope of the present disclosure.

### BRIEF DESCRIPTION OF THE DRAWINGS

FIG. 1 is a block diagram schematically showing an image sensor according to an embodiment.
FIG. 2 is a top plan view showing a portion of an image sensor according to an embodiment.
FIG. 3 is a circuit diagram of an image sensor according to an embodiment.
FIG. 4 is a top plan view of an image sensor according to an embodiment.
FIG. 5 is a cross-sectional view taken along line I-I' of FIG. 4.
FIG. 6 is a top plan view showing pixel separation structure of an image sensor according to an embodiment.
FIG. 7 is a cross-sectional view taken along line II-II' of FIG. 6.
FIG. 8 is a top plan view of an image sensor according to another embodiment.
FIG. 9 is a top plan view of an image sensor according to another embodiment.
FIG. 10 is a top plan view showing a pixel separation structure of an image sensor according to an embodiment.
FIG. 11 is a top plan view of an image sensor according to another embodiment.
FIG. 12 is a top plan view showing a pixel separation structure of an image sensor according to another embodiment.
FIG. 13 is a top plan view of an image sensor according to another embodiment.
FIG. 14 is a top plan view showing pixel separation structure of an image sensor according to another embodiment.
FIG. 15 is a top plan view of an image sensor according to another embodiment.
FIG. 16 is a top plan view showing pixel separation structure of an image sensor according to another embodiment.
FIG. 17 is a circuit diagram of an image sensor according to another embodiment.
FIG. 18 is a top plan view of an image sensor according to another embodiment.
FIG. 19 is a top plan view of an image sensor according to another embodiment.
FIG. 20 is a top plan view of an image sensor according to another embodiment.
FIG. 21 is a top plan view of an image sensor according to another embodiment.
FIG. 22 is a top plan view of an image sensor according to another embodiment.
FIG. 23 shows a schematic stacking structure of an image sensor according to another embodiment.
FIG. 24 shows a schematic stacking structure of an image sensor according to another embodiment.

### DETAILED DESCRIPTION

The present disclosure will be described more fully hereinafter with reference to the accompanying drawings, in which embodiments of the disclosure are shown. As those skilled in the art would realize, the described embodiments may be modified in various different ways, all without departing from the spirit or scope of the present disclosure.

In order to clearly describe the present disclosure, various parts or portions that are known or that may not be relevant toward the inventive features are omitted, and identical or similar constituent elements throughout the specification are denoted by the same reference numerals.

In addition, the accompanying drawings are provided only in order to allow embodiments disclosed in the present specification to be easily understood and are not to be interpreted as limiting the spirit disclosed in the present specification, and it is to be understood that the present disclosure includes all modifications, equivalents, and substitutions without departing from the scope and spirit of the present disclosure.

Further, in the drawings, the size and thickness of each element are arbitrarily illustrated for ease of description, and the present disclosure is not necessarily limited to those illustrated in the drawings. In the drawings, the thicknesses of layers, films, panels, regions, areas, etc., are exaggerated for clarity. In the drawings, for ease of description, the thicknesses of some layers and areas are exaggerated.

It will be understood that when an element such as a layer, film, region, area, or substrate is referred to as being "on" or "above" another element, it can be directly on the other element or intervening elements may also be present. In contrast, when an element is referred to as being "directly on" another element, there are no intervening elements present. Further, in the specification, the word "on" may refer to being above or below an element, and the words "above" or "below" may depend on an orientation on which an element is viewed, and does not necessarily mean disposed on the upper side or lower side of the element based on a gravitational direction.

In addition, unless explicitly described to the contrary, the word "comprise" and variations such as "comprises" or "comprising" will be understood to imply the inclusion of stated elements but not the exclusion of any other elements.

Further, throughout the specification, the phrase "in a plan view" or "on a plane" means viewing a target portion from the top, and the phrase "in a cross-sectional view" or "on a cross-section" means viewing a cross-section formed by vertically cutting a target portion from the side.

Furthermore, throughout the specification, "connected" does not only mean when two or more elements are directly connected, but also when two or more elements are indirectly connected through other elements, and when they are physically connected or electrically connected, and further, it may be referred to by different names depending on a position or function, and may also be referred to as a case in which respective parts that are substantially integrated are linked to each other.

Ordinal numbers such as "first," "second," "third," etc. may be used simply as labels of certain elements, steps, etc., to distinguish such elements, steps, etc. from one another. Terms that are not described using "first," "second," etc., in the specification, may still be referred to as "first" or "second" in a claim. In addition, a term that is referenced with a particular ordinal number (e.g., "first") in a particular claim may be described elsewhere with a different ordinal number (e.g., "second") in the specification or another claim.

It will be understood that when an element is referred to as being "connected" or "coupled" to or "on" another element, it can be directly connected or coupled to or on the other element or intervening elements may be present. In contrast, when an element is referred to as being "directly connected" or "directly coupled" to another element, or as "contacting" or "in contact with" another element (or using any form of the word "contact"), there are no intervening elements present at the point of contact or at a point where the elements connect.

It will be understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

Hereinafter, various embodiments and variations will be described in detail with reference to the drawings.

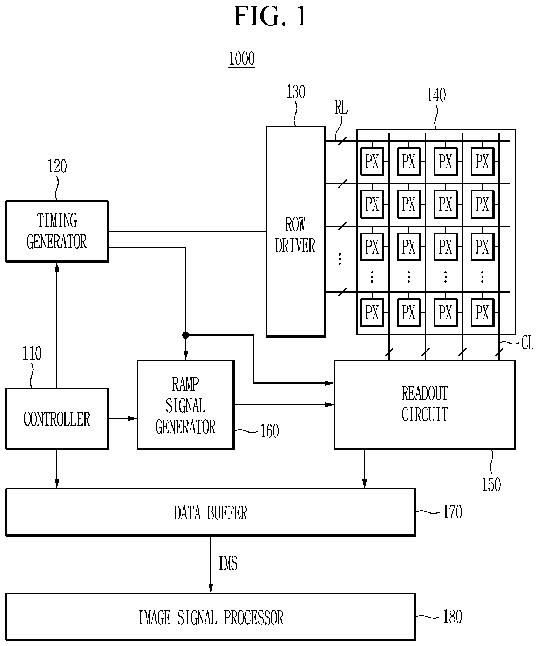

Referring to FIG. 1, an image sensor according to an embodiment will be schematically described. FIG. 1 is a block diagram schematically showing an image sensor according to an embodiment.

Referring to FIG. 1, an image sensor 1000 according to an embodiment may include a pixel array 140 and a logic circuit for controlling the pixel array 140.

The logic circuit is a circuit for controlling the pixel array 140, and may include, for example, a controller 110, a timing generator 120, a row driver 130, a readout circuit 150, a ramp signal generator 160, data buffer 170, and the like.

In addition, the image sensor 1000 may further include an image signal processor 180, and according to another embodiment, the image signal processor 180 may be located outside image sensor 1000. The image sensor 1000 may convert an externally received light into an electric signal, to generate an image signal. The image signal may be provided to the image signal processor 180.

The image sensor 1000 may be installed in an electronic device having an image or light sensing function. For example, the image sensor 1000 may be installed in an electronic device such as a camera, a smart phone, a wearable device, an Internet of Things (IoT) device, a home appliance, a tablet personal computer (PC), a navigation, a drone, an advanced driver assistance system (ADAS). In addition, the image sensor 1000 may be installed in an electronic device provided in vehicles, furniture, manufacture facilities, doors, various measurement devices, or the like, as a component part.

The pixel array 140 may include a plurality of row lines RL, and a plurality of column lines CL connected to a plurality of pixels PX.

In an embodiment, each pixel PX may include at least one photoelectric conversion region. The photoelectric conversion region may detect an incident light, and may convert the incident light into an electric signal according to an amount of light, i.e., a plurality of analog pixel signals.

The photoelectric conversion region may be a photodiode, a pinned diode, or the like. In addition, the photoelectric conversion region may be a single-photon avalanche diode (SPAD) applied to a 3D sensor pixel.

The level of the analog pixel signal output from the photoelectric conversion region may be proportional to the amount of charge output from the photoelectric conversion region. For example, a level of the analog pixel signal output from the photoelectric conversion region may be determined according to the amount of light received into the pixel array 140.

The plurality of row lines RL may be connected to the plurality of pixels PX. For example, the control signal output from the row driver 130 to the row line RL may be transferred to gates of transistors of the plurality of pixels PX connected to the corresponding row line RL. The column line CL may be disposed to cross the row line RL, and connected to the plurality of pixels PX. A plurality of pixel signals output from the plurality of pixels PX may be transferred to the readout circuit 150 through the plurality of column lines CL.

The controller 110 may control operation timings of the components 120, 130, 150, 160, and 170 described above by using the control signals.

In an embodiment, the controller 110 may receive a mode signal indicating an imaging mode from an application processor, and may generally control the image sensor 1000 based on the received mode signal. For example, the application processor may determine the imaging mode of the image sensor 1000 based on various scenarios such as the lighting conditions of the imaging environment, the user's resolution settings, states that are sensed or learned, etc., and provide the determined result as the mode signal to the controller 110.

The controller 110 may control the plurality of pixels PX of the pixel array 140 to output the pixel signal according to the imaging mode, the pixel array 140 may output the pixel signal with respect to each of the plurality of pixels PX or the pixel signal with respect to a part (e.g., a subset) of the plurality of pixels PX, and the readout circuit 150 may sample and process the pixel signals transferred from the pixel array 140.

The timing generator 120 may generate a signal that serves as a reference for operation timings of components of the image sensor 1000. The timing generator 120 may control timings of the row driver 130, the readout circuit 150, and the ramp signal generator 160. The timing generator 120 may provide the control signal for controlling timings of the row driver 130, the readout circuit 150, and the ramp signal generator 160.

The row driver 130 may generate the control signal for driving the pixel array 140 in response to the control signal of the timing generator 120, and may provide the control signal to the plurality of pixels PX of the pixel array 140 through the plurality of row lines RL.

In an embodiment, the row driver 130 may control the pixel PX to detect the incident light on a row line basis. The row line unit may include at least one row line RL. For example, the row driver 130 may generate a transmission signal for controlling a transmission transistor, a reset control signal for controlling a reset transistor, a selection control signal for controlling a selection transistor, or the like, and may provide it to the pixel array 140.

The readout circuit 150 may convert the pixel signal (or electric signal) from the pixel PX connected to the row line RL selected from among the plurality of pixels PX into the pixel value representing the amount of light in response to the control signal from the timing generator 120.

The readout circuit 150 may convert the pixel signal output through the corresponding column line CL into the pixel value. For example, the readout circuit 150 may convert the pixel signal into the pixel value by comparing the ramp signal and the pixel signal. The pixel value may be an image data having a plurality of bits. Specifically, the readout circuit 150 may include a selector, a plurality of comparators, and a plurality of counter circuits, or the like.

The ramp signal generator 160 may generate a reference signal and transmit it to the readout circuit 150. The ramp signal generator 160 may include a current source, a resistor, and a capacitor. The ramp signal generator 160 may adjust a current of a variable current source or a resistance value of a variable resistor to adjust a ramp voltage, which is a voltage across a ramp resistance, and thereby may generate a plurality of ramp signals rising or falling at a slope determined according to the current of the variable current source or the resistance value of the variable resistor.

The data buffer 170 may store the pixel values of the plurality of pixels PX connected to the selected column line CL transferred from the readout circuit 150, and may output the stored pixel value in response to an enable signal from the controller 110.

The image signal processor 180 may perform an image signal processing on the image signal received from the data buffer 170. For example, the image signal processor 180 may receive a plurality of image signals from the data buffer 170, and may synthesize the received image signal to generate one image.

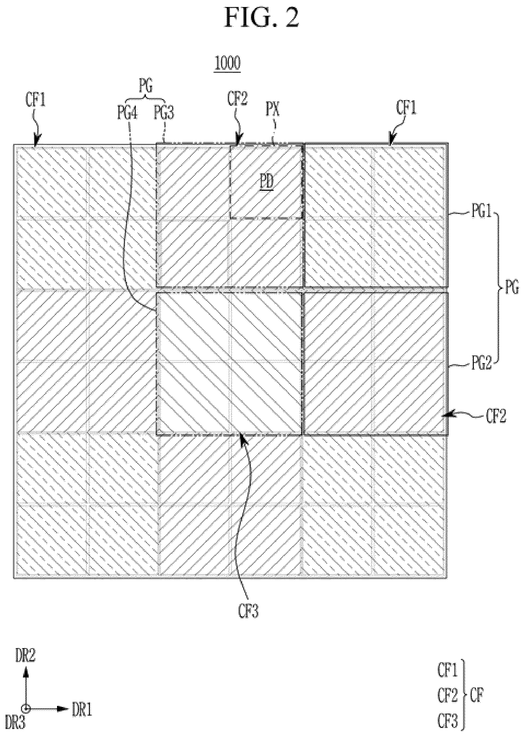

Referring to FIG. 2, a pixel arrangement of an image sensor according to an embodiment will be described. FIG. 2 is a top plan view showing a portion of an image sensor according to an embodiment.

Referring to FIG. 2, the image sensor 1000 according to an embodiment may include pixel groups PG1, PG2, PG3, and PG4, photodiodes PD, color filters CF, and other circuits required for an operation of the image sensor 1000.

Each of the plurality of pixels PX may include one photodiode PD.

The plurality of pixels PX may be combined in the form of a plurality of columns and a plurality of rows, to configure the pixel groups PG1, PG2, PG3, and PG4.

A first pixel group PG1 overlapping with a first color filter CF1 may absorb and detect light of the first color, a second pixel group PG2 overlapping with a second color filter CF2 and a third pixel group PG3 overlapping with the second color filter CF2 may absorb and detect light of the second color different from the first color, and a fourth pixel group PG4 overlapping with a third color filter CF3 may absorb and detect light of the third color different from the first color and the second color.

According to another embodiment, the image sensor 1000 may further include the fourth pixel group configured to absorb and detect all visible rays.

Each of the pixel groups PG1, PG2, PG3, and PG4 may include NxM pixels PX of NxM arrangement. Here, N and M may be integers greater than 1, independently. For example, N and M may be 2, respectively, and may have a pixel arrangement of 2x2 Tetra structure, in a plan view. That is, each of the pixel groups PG1, PG2, PG3, and PG4 may include the pixels PX arranged in the form of 2×2 in a plan view.

In more detail, the plurality of pixels PX disposed along a first direction DR1 and the plurality of pixels PX disposed along a second direction DR2 may configure each of the pixel groups PG1, PG2, PG3, and PG4. However, the embodiments are not limited thereto, and the number of the pixels PX included in each of the pixel groups PG1, PG2, PG3, and PG4 may be modified in various ways.

The image sensor 1000 according to the present embodiment may include a first pixel row in which the first pixel group PG1 corresponding to the first color filter CF1 and the third pixel group PG3 corresponding to the second color filter CF2 are alternately disposed along the first direction DR1, and a second pixel row in which the second pixel group PG2 corresponding to the second color filter CF2 and the fourth pixel group PG4 corresponding to the third color filter CF3 are alternately disposed along the first direction DR1, and the first pixel row and the second pixel row may be alternately disposed along the second direction DR2.

The image sensor 1000 according to the present embodiment may include a plurality of pixel regions PG including two pixel groups among the first pixel group PG1, the second pixel group PG2, the third pixel group PG3, and the fourth pixel group PG4. The two pixel groups included in each pixel region PG may be adjacent to each other along the second direction DR2, but the embodiments are not limited thereto, and the two pixel groups included in each pixel region PG may be adjacent to each other along the first direction DR1.

The image sensor 1000 according to an embodiment may further include microlenses, and at least one microlens may be located in each of the pixel groups PG1, PG2, PG3, and PG4.

The image sensor 1000 according to an embodiment may further include photodiodes PD located in each of the plurality of pixels PX.

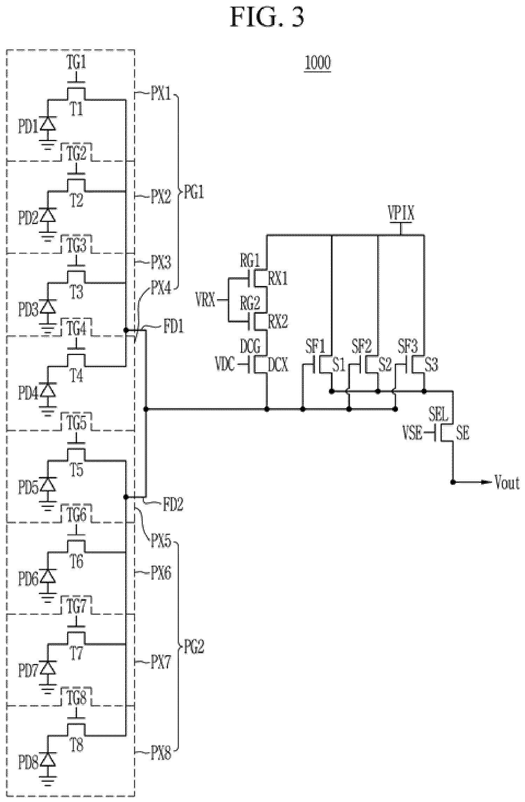

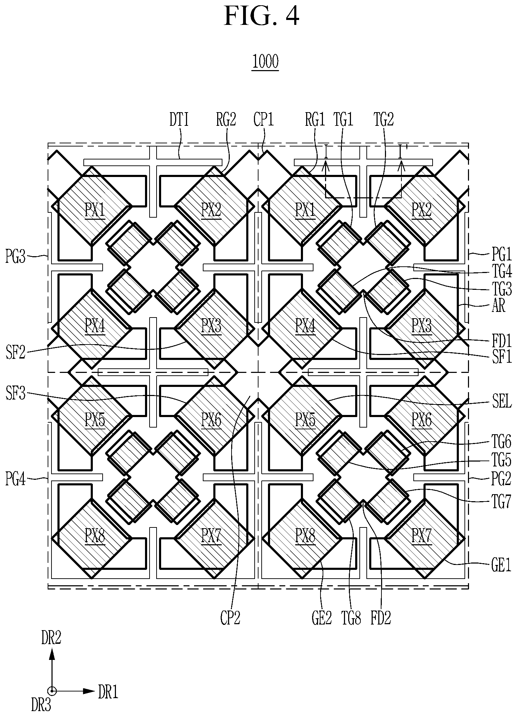

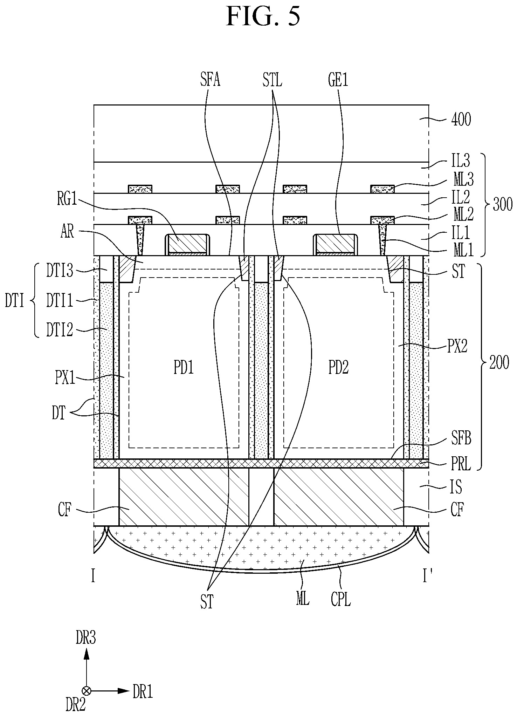

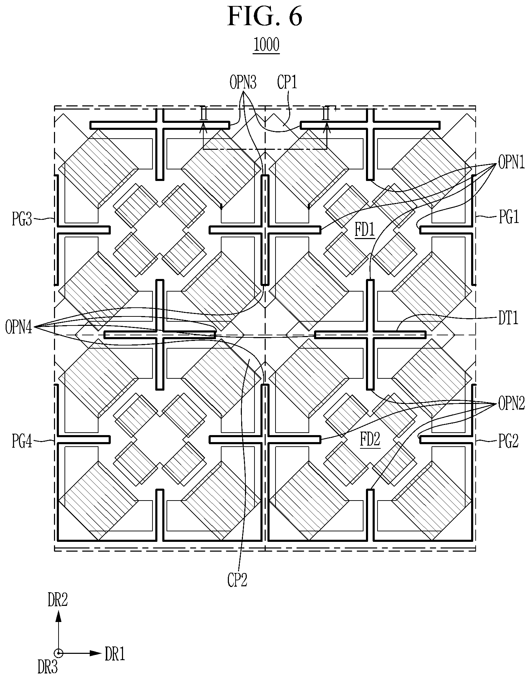

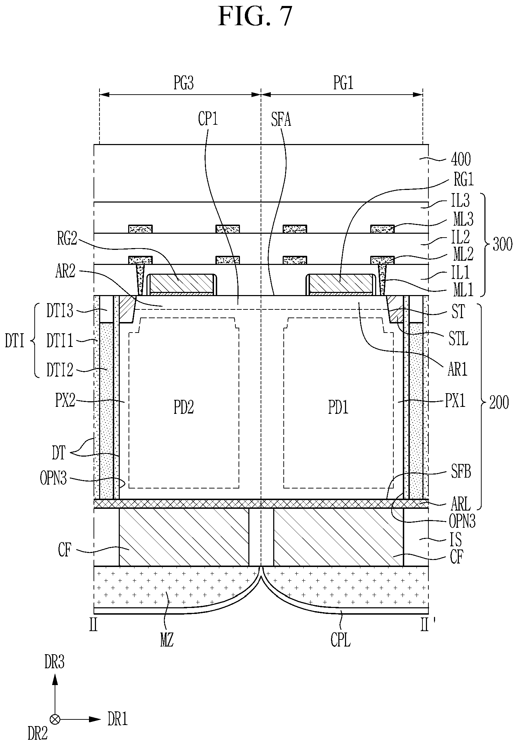

Referring to FIG. 3 to FIG. 7 together with FIG. 2, one pixel region of an image sensor according to an embodiment will be described. FIG. 3 is a circuit diagram of an image sensor according to an embodiment. FIG. 4 is a top plan view of an image sensor according to an embodiment. FIG. 5 is a cross-sectional view along line I-I' of FIG. 4. FIG. 6 is a top plan view showing a pixel separation structure of an image sensor according to an embodiment. FIG. 7 is a cross-sectional view taken along line II-II' of FIG. 6.

Referring to FIG. 3 together with FIG. 2, the image sensor 1000 according to an embodiment may include the first pixel group PG1 and the second pixel group PG2, and the first pixel group PG1 and the second pixel group PG2 may include pixels PX1 to PX8, the photoelectric conversion regions PD1 to PD8, transmission transistors T1 to T8, reset transistor RX1 and RX2, a dual conversion transistor DCX, source follower transistors S1 to S3, and a selection transistor SE. As described above, it is illustrated that in each of the first pixel group PG1 and the second pixel group PG2, four pixels PX1 to PX4 or PX5 to PX8 include the photoelectric conversion regions PD1 to PD4 or PD5 to PD8, respectively, but the embodiments are not limited thereto.

A first pixel PX1 may include a first photoelectric conversion region PD1 and a first transmission transistor T1, a second pixel PX2 may include a second photoelectric conversion region PD2 and a second transmission transistor T2, a third pixel PX3 may include a third photoelectric conversion region PD3 and a third transmission transistor T3, and a fourth pixel PX4 may include a fourth photoelectric conversion region PD4 and a fourth transmission transistor T4.

A fifth pixel PX5 may include a fifth photoelectric conversion region PD5 and a fifth transmission transistor T5, a sixth pixel PX6 may include a sixth photoelectric conversion region PD6 and a sixth transmission transistor T6, a seventh pixel PX7 may include a seventh photoelectric conversion region PD7 and a seventh transmission transistor T7, and an eighth pixel PX8 may include an eighth photoelectric conversion region PD8 and an eighth transmission transistor T8.

The pixels PX1 to PX4 of the first pixel group PG1 may share a first floating diffusion region FD1.

The pixels PX5 to PX8 of the second pixel group PG2 may share a second floating diffusion region FD2.

The first pixel group PG1 and the second pixel group PG2 may share the reset transistor RX1 and RX2, the dual conversion transistor DCX, the source follower transistors S1 to S3, and the selection transistor SE. The first floating diffusion region FD1 or the second floating diffusion region FD2 may accumulate charges corresponding to the amount of the incident light.

While the transmission transistors T1 to T4 are turned on by the transmission signals, respectively, the first floating diffusion region FD1 or the second floating diffusion region FD2 may be provided with charges from the photoelectric conversion regions PD1 to PD4 and accumulate the charges.

The reset transistor RX1 and RX2 may be driven by a reset signal VRX, and may provide a power source voltage to the first floating diffusion region FD1 or the second floating diffusion region FD2. Accordingly, the charges accumulated in the first floating diffusion region FD1 or the expanded second floating diffusion region FD2 may move to a power source voltage VPIX, and the voltage of the first floating diffusion region FD1 or the second floating diffusion region FD2 may be reset.

The source follower transistors S1, S2, and S3 may be connected between the power source voltage VPIX and the selection transistor SE. The source follower transistors S1, S2, and S3 may output an output signal Vout to the selection transistor SE based on the voltage level of the first floating diffusion region FD1 or the second floating diffusion region FD2. The selection transistor SE may be driven by a selection signal VSE, and when the selection transistor SE is turned on, the output signal Vout may be output to the readout circuit 150 through the column line CL.

The dual conversion transistor DCX may be connected between the floating diffusion regions FD1 and FD2 and the reset transistors RX1 and RX2. When the dual conversion transistor DCX is turned off by a dual conversion signal VDC, the Full Well Capacity (FWC) of each of the pixels PX1 to PX8 may be the capacitance of the first floating diffusion region FD1 and the second floating diffusion region FD2. When the dual conversion transistor DCX is turned on by the dual conversion signal VDC, the FWC of each of the pixels PX1 to PX8 may increase to be greater than the capacitance of the first floating diffusion region FD1. According to turning on and off of the dual conversion transistor DCX, the conversion gain of each of the pixels PX1 to PX8 may be varied.

Referring to FIG. 4 and FIG. 5 together with FIG. 2 and FIG. 3, the structure of the first pixel group PG1 and the second pixel group PG2 of the image sensor 1000 according to an embodiment will be described in further detail.

As described above, the image sensor 1000 according to an embodiment may include the pixel region PG including the first pixel group PG1 and the second pixel group PG2 that absorb and detect different colors.

The first pixel group PG1 may include the first pixel PX1, the second pixel PX2, the third pixel PX3 and the fourth pixel PX4 that are disposed along a clockwise direction, and the second pixel group PG2 may include the fifth pixel PX5, the sixth pixel PX6, the seventh pixel PX7 and the eighth pixel PX8 that are disposed along the clockwise direction.

A pixel separation structure DTI may be located between a plurality of pixels PX1, PX2, PX3, PX4, PX5, PX6, PX7, and PX8.

The pixel separation structure DTI may be located to surround at least a portion of the edge of the first pixel group PG1 and the second pixel group PG2. In addition, the pixel separation structure DTI may surround at least a portion of the edge of each of the first pixel PX1, the second pixel PX2, the third pixel PX3 and the fourth pixel PX4 of the first pixel group PG1, and may surround at least a portion of the edge of each of the fifth pixel PX5, the sixth pixel PX6, the seventh pixel PX7 and the eighth pixel PX8 of the second pixel group PG2.

The pixel separation structure DTI may prevent crosstalk between the plurality of pixels PX1, PX2, PX3, PX4, PX5, PX6, PX7, and PX8. The pixel separation structure DTI may be in the form of a wall (or plurality of walls), and in some embodiments may be a pixel separation wall.

The image sensor 1000 may include a substrate 200. The substrate 200 may include silicon (Si), germanium (Ge), or silicon (Si)-germanium (Ge). The substrate 200 may include gallium arsenide (GaAs), indium phosphide (InP), gallium phosphide (GaP), indium arsenide (InAs), indium antimonide (InSb), or indium gallium arsenide (InGaAs). The substrate 200 may include zinc telluride (ZnTe), or cadmium sulfide (CdS).

The substrate 200 may be a bulk silicon or silicon-on-insulator (SOI). The substrate 200 may be a silicon substrate, or may include another material, for example, silicon germanium, indium antimonide, lead tellurium compound, indium arsenide, indium phosphide, gallium arsenide or gallium antimonide instead of or in addition to silicon. In some embodiments, the substrate 200 may be one in which an epitaxial layer is formed on a base substrate.

The substrate 200 may be doped with impurities of a first conductivity type. For example, the first conductivity type may be a P-type.

The substrate 200 may include a first surface SFA and a second surface SFB opposite each other.

The substrate 200 may include a deep trench DT, and the pixel separation structure DTI may be located within the deep trench DT of the substrate 200.

The pixel separation structure DTI may be located within the deep trench DT, and at least a portion of the deep trench DT may be surrounded by a device isolation portion STL (e.g., a device isolation region) located within a shallow trench ST.

As described above, the pixel separation structure DTI may be located to surround at least a portion of the edge of the first pixel group PG1 and the second pixel group PG2. In addition, the pixel separation structure DTI may surround at least a portion of the edge of each of the first pixel PX1, the second pixel PX2, the third pixel PX3 and the fourth pixel PX4 of the first pixel group PG1, and may surround at least a portion of the edge of each of the fifth pixel PX5, the sixth pixel PX6, the seventh pixel PX7 and the eighth pixel PX8 of the second pixel group PG2.

The deep trench DT and the pixel separation structure DTI may penetrate the substrate 200 from the first surface SFA to the second surface SFB of the substrate 200.

The pixel separation structure DTI may include a first pattern DTI1, a second pattern DTI2 and a third pattern DTI3. The first pattern DTI1 may cover an inner sidewall of the deep trench DT. The third pattern DTI3 may fill an upper portion of the deep trench DT. The second pattern DTI2 may fill a lower portion of the deep trench DT.

The first pattern DTI1 may extend from the first surface SFA to the second surface SFB of the substrate 200. The second pattern DTI2 may be separated from the substrate 200 by the first pattern DTI1. In another embodiment, the third pattern DTI3 may be omitted.

The first pattern DTI1 and the third pattern DTI3 may include silicon oxide, silicon nitride, or silicon oxynitride. The first pattern DTI1 may include metal oxides such as hafnium oxide, aluminum oxide, tantalum oxide, or the like, and in this case, the first pattern DTI1 may act as a negative fixed charge layer. The second pattern DTI2 may include, for example, semiconductor materials such as polysilicon doped with N-type or P-type impurities.

Within the substrate 200, photoelectric conversion regions PD1, PD2, PD3, PD4, PD5, PD6, PD7, and PD8 corresponding to the pixels PX1, PX2, PX3, PX4, PX5, PX6, PX7, and PX8 may be located.

The externally incident light may be converted into electrical signals in the photoelectric conversion regions PD1, PD2, PD3, PD4, PD5, PD6, PD7, and PD8. The photoelectric conversion regions PD1, PD2, PD3, PD4, PD5, PD6, PD7, and PD8 may include a photodiode formed inside substrate 200. The photoelectric conversion regions PD1, PD2, PD3, PD4, PD5, PD6, PD7, and PD8 may be doped with an impurity of the different type from the impurity doped into the substrate 200.

The photoelectric conversion regions PD1, PD2, PD3, PD4, PD5, PD6, PD7, and PD8 may be doped with impurity of a second conductivity type different from the impurity of the first conductivity type doped into the substrate 200. For example, the substrate 200 may be doped with P-type impurities, and the photoelectric conversion regions PD1, PD2, PD3, PD4, PD5, PD6, PD7, and PD8 may be doped with N-type impurities.

The N-type impurity regions of the photoelectric conversion regions PD1, PD2, PD3, PD4, PD5, PD6, PD7, and PD8 may form PN junctions with the surrounding P-type impurity region of the substrate 200, configuring photodiodes, and when light is incident, these PN junctions may generate electron-hole pairs.

The pixel separation structure DTI may be located between the photoelectric conversion regions PD1, PD2, PD3, PD4, PD5, PD6, PD7, and PD8 corresponding to the plurality of pixels PX1, PX2, PX3, PX4, PX5, PX6, PX7, and PX8, such that the photoelectric conversion regions PD1, PD2, PD3, PD4, PD5, PD6, PD7, and PD8 corresponding to the plurality of pixels PX1, PX2, PX3, PX4, PX5, PX6, PX7, and PX8, respectively, may be separated from each other by the pixel separation structure DTI. The pixel separation structure DTI may electrically and optically isolate photoelectric conversion regions PD1, PD2, PD3, and PD4 adjacent to each other.

The substrate 200 may include the shallow trench ST, and the device isolation portion STL may be located within the shallow trench ST of the substrate 200. The shallow trench ST may not fully penetrate the substrate 200 from the first surface SFA of the substrate 200, and may be located in a portion of the substrate 200 to partially pass through the substrate in a vertical direction. The depth of the shallow trench ST along a third direction DR3, which is a height direction, may be smaller than the depth of the deep trench DT. The device isolation portion STL may include silicon oxide, silicon nitride, or a combination thereof.

Contrarily, the device isolation portion STL may be a region where the impurity of the first conductivity type, which is the same as the impurity doped into the substrate 200, is doped at a higher concentration than the doping concentration of the impurity doped into the substrate 200.

The pixel separation structure DTI may penetrate and pass through a device isolation portion ST.

A plurality of gates TG1 to TG8, RG1, SF1, SEL, GE1, and GE2 may be located above the first surface SFA of the substrate 200.

The plurality of pixels PX1, PX2, PX3, PX4, PX5, PX6, PX7, and PX8 each may include active regions AR located adjacent to the first surface SFA of the substrate 200 in the substrate 200. The active regions AR each may be separated by the device isolation portion STL.

The substrate 200 may include a plurality of floating diffusion regions FD1 and FD2 and ground regions (not shown) located adjacent to the first surface SFA.

The first floating diffusion region FD1 may be adjacent to the transfer gates TG1, TG2, TG3, and TG4, and the second floating diffusion region FD2 may be adjacent to the transfer gates TG5, TG6, TG7, and TG8. The plurality of floating diffusion regions FD1 and FD2 may be doped with impurity of the second conductivity type different from the impurity of the first conductivity type doped into the substrate 200.

The ground regions may be doped with an impurity of the same type as the impurity doped into the remaining substrate 200, and the concentration of the doped impurity may be higher than the concentration of other portions of the substrate 200.

The active regions AR of the plurality of pixels PX1, PX2, PX3, PX4, PX5, PX6, PX7, and PX8 may be active regions for the operation of a plurality of transistors.

The plurality of gates TG1 to TG8, RG1, SF1, SEL, GE1 and GE2 may be located on the active regions AR of the plurality of pixels PX1, PX2, PX3, PX4, PX5, PX6, PX7, and PX8.

The plurality of gates TG1 to TG8, RG1, SF1, SEL, GE1 and GE2, and floating diffusion regions FD1 and FD2 may form the transmission transistors T1 to T8, the source follower transistor S1, the selection transistor SE, the reset transistor RX1, and the dual conversion transistor DCX. The ground regions may be a ground pattern for grounding at least one of the transmission transistors T1 to T8, selection transistor (S1 to S3), the reset transistor RX1 and RX2, and the dual conversion transistor DCX.

A first structure 300 may be disposed on the first surface SFA of the substrate 200. The first structure 300 may include a plurality of vias ML1, a plurality of wire layers ML2 and ML3, and a plurality of insulation layers IL1, IL2, and IL3. The plurality of insulation layers IL1, IL2, and IL3 may electrically separate the plurality of vias ML1 and the plurality of wire layers ML2 and ML3.

The plurality of vias ML1 and the plurality of wire layers ML2 and ML3 may be electrically connected to the transistors on the first surface SFA of the substrate 200.

The plurality of vias ML1 and the plurality of wire layers ML2 and ML3 may include tungsten, aluminum, copper, tungsten silicide, titanium silicide, tungsten nitride, titanium nitride, doped polysilicon, or the like.

The plurality of insulation layers IL1, IL2, and IL3 may include an insulating material of silicon oxide, silicon nitride, silicon oxynitride, low-k material, or the like. Low-dielectric material may include, for example, at least one of flowable oxide (FOx), Torene SilaZene (TOSZ), undoped silica glass (USG), borosilica glass (BSG), phosphosilicate glass (PSG), borophosphosilicate glass (BPSG), plasma-enhanced tetraethyl orthosilicate (PETEOS), fluorosilicate glass (FSG), carbon-doped silicon oxide (CDO), xerogel, aerogel, amorphous fluorinated carbon, organosilicate glass (OSG), parylene, bis-benzocyclobutenes (BCB), SiLK, polyimide, porous polymeric material and a combination thereof.

The image sensor 1000 may further include a support substrate 400 located on the first structure 300, a but the support substrate 400 may be omitted. Between the support substrate 400 and the first structure 300, an adhesive member (not shown) may be further located.

An anti-reflection layer PRL may be located on the second surface SFB of the substrate 200. The anti-reflection layer PRL may cover the pixel separation structure DTI and the second surface SFB of the substrate 200.

The anti-reflection layer PRL may include hafnium oxide (HfO₂), silicon oxide (SiO₂), silicon nitride (SiN), aluminum oxide (Al₂O₃), zirconium oxide (ZrO₂), tantalum oxide (Ta₂O₅), titanium oxide (TiO₂), lanthanum oxide (La₂O₃), praseodymium oxide (Pr₂O₃), cerium oxide (CeO₂), neodymium oxide (Nd₂O₃), promethium oxide (Pm₂O₃), samarium oxide (Sm₂O₃), europium oxide (Eu₂O₃), gadolinium oxide (Gd₂O₃), terbium oxide (Tb₂O₃), dysprosium oxide (Dy₂O₃), holmium oxide (Ho₂O₃), thulium oxide (Tm₂O₃), ytterbium oxide (Yb₂O₃), lutetium oxide (Lu₂O₃), yttrium oxide (Y₂O₃), or a combination thereof.

In an embodiment, the anti-reflection layer PRL may include a plurality of layers including different materials and having different thicknesses. For example, the anti-reflection layer PRL may include a first anti-reflection layer to a third anti-reflection layer sequentially stacked on the second surface SFB of the substrate 200.

The first anti-reflection layer may be the fixed charge layer having a negative fixed charge. Hole accumulation may occur around the fixed charge layer, and due to this, generation of a dark current and/or a white spot may be effectively decreased.

The third anti-reflection layer may include a metal oxide or metal fluoride including at least one of hafnium (Hf), zirconium (Zr), aluminum (Al), tantalum (Ta), titanium (Ti), and yttrium (Y). For example, the first anti-reflection layer and the third anti-reflection layer may include a hafnium oxide layer, and the second anti-reflection layer may include silicon oxide and/or silicon nitride. However, in another embodiment, the number and relative thickness of the layers constituting the anti-reflection layer PRL may be modified in various ways.

In addition, in another embodiment, the anti-reflection layer PRL may further include a silicon nitride layer disposed between the second anti-reflection layer and the third anti-reflection layer.

Fence patterns IS may surround color filters CF.

The fence patterns IS may include a low refractive index material. Low refractive index material may have a refractive index greater than about 1.0 and smaller than or equal to about 1.4. For example, low refractive index material may include polymethyl metacrylate (PMMA), silicon acrylate, cellulose acetatebutyrate (CAB), silica, or fluoro-silicon acrylate (FSA). For example, low refractive index material may include a polymer material in which silica (SiOx) particles are dispersed.

When the fence patterns IS include a low refractive index material having a relatively low refractive index, the incident light may be totally reflected at the fence patterns IS, and directed towards a central axis of each of the pixel regions PX1, PX2, PX3, PX4, PX5, PX6, PX7, and PX8.

The fence patterns IS may prevent light that enters obliquely into the color filter CF disposed over one of the plurality of pixel regions PX1, PX2, PX3, PX4, PX5, PX6, PX7, and PX8 from entering the color filter CF disposed over an adjacent pixel region, and accordingly, crosstalk between the plurality of pixel regions PX1, PX2, PX3, PX4, PX5, PX6, PX7, and PX8 may be prevented.

A plurality of color filters CF may be disposed on the anti-reflection layer PRL, and may be separated from each other by the fence pattern IS. The plurality of color filters CF may include, for example, a green filter, a blue filter, and a red filter. The plurality of color filters CF may include, for example, cyan, magenta, or yellow. Microlens ML may be disposed on the color filter CF and the fence pattern IS. The microlens ML may be transparent.

The microlens ML may be formed from resin-based materials such as styrene-based resin, acrylic-based resin, styrene-acrylic copolymer-based resin, siloxane-based resin, or the like.

The microlens ML may concentrate the incident light, and the concentrated light may then be incident through the color filter CF to the photoelectric conversion regions PD1, PD2, PD3, PD4, PD5, PD6, and PD8.

A capping layer CPL may be disposed on the microlens ML and may protect the microlens ML.

Referring to FIG. 4, the image sensor 1000 may further include the third pixel group PG3 and the fourth pixel group PG4 adjacent to the first pixel group PG1 and the second pixel group PG2 along the first direction DR1.

The first pixel PX1, the second pixel PX2, the third pixel PX3, and the fourth pixel PX4 of the first pixel group PG1 may share the first floating diffusion region FD1.

The first floating diffusion region FD1 may be located in a portion of each of the first pixel PX1, the second pixel PX2, the third pixel PX3, the fourth pixel PX4 of the first pixel group PG1, and the first floating diffusion region FD1 of each of the first pixel PX1, the second pixel PX2, the third pixel PX3, and the fourth pixel PX4 may be integrally formed.

The first floating diffusion region FD1 may not overlap with the pixel separation structure DTI along the third direction DR3, which is the height direction.

For example, the pixel separation structure DTI may not be formed in the region corresponding to the first floating diffusion region FD1.

The first pixel PX1, the second pixel PX2, the third pixel PX3, and the fourth pixel PX4 of the first pixel group PG1 may include a first transmission gate electrode TG1, a second transmission gate electrode TG2, a third transmission gate electrode TG3, and a fourth transmission gate electrode TG4 located on the active region AR, and the first floating diffusion region FD1 may be formed in a portion of the active region AR, and located on a side of the first transmission gate electrode TG1, the second transmission gate electrode TG2, the third transmission gate electrode TG3, and the fourth transmission gate electrode TG4.

The fifth pixel PX5, the sixth pixel PX6, the seventh pixel PX7, and the eighth pixel PX8 of the second pixel group PG2 may share the second floating diffusion region FD2.

The second floating diffusion region FD2 may be located in a portion of each of the fifth pixel PX5, the sixth pixel PX6, the seventh pixel PX7, the eighth pixel PX8 of the second pixel group PG2, and the second floating diffusion region FD2 of each of the fifth pixel PX5, the sixth pixel PX6, the seventh pixel PX7, the eighth pixel PX8 may be integrally formed.

The second floating diffusion region FD2 may not overlap with the pixel separation structure DTI along the third direction DR3, which is the height direction.

For example, the pixel separation structure DTI may not be formed in the region corresponding to the second floating diffusion region FD2.

The fifth pixel PX5, the sixth pixel PX6, the seventh pixel PX7, and the eighth pixel PX8 of the second pixel group PG2 may include a fifth transmission gate electrode TG5, a sixth transmission gate electrode TG6, a seventh transmission gate electrode TG7, and an eighth transmission gate electrode TG8 located on the active region AR, and the second floating diffusion region FD2 may be formed in a portion of the active region AR and may be located on a side of the fifth transmission gate electrode TG5, the sixth transmission gate electrode TG6, the seventh transmission gate electrode TG7, and the eighth transmission gate electrode TG8.

A first reset gate electrode RG1 may be located above the active region AR of the first pixel PX1 of the first pixel group PG1, and a second reset gate electrode RG2 may be located above the active region AR of the second pixel PX2 of the third pixel group PG3 disposed adjacent to the first pixel group PG1 along the first direction DR1 and configured to absorb and detect light of a color different from the first pixel group PG1.

A first source follower gate electrode SF1 may be located above the active region AR of the fourth pixel PX4 of the first pixel group PG1.

A second source follower gate electrode SF2 may be located above the active region AR of the third pixel PX3 of the third pixel group PG3 disposed adjacent to the first pixel group PG1 along the first direction DR1 and configured to absorb and detect light of a color different from the first pixel group PG1.

A third source follower gate electrode SF3 may be located above the active region AR of the sixth pixel PX6 of the fourth pixel group PG4 disposed adjacent to the second pixel group PG2 along the first direction DR1 and configured to absorb and detect light of a color different from the second pixel group PG2.

A selection gate electrode SEL may be located above the active region AR of the fifth pixel PX5 of the second pixel group PG2.

However, unlike this example, according to another embodiment, the third source follower gate electrode SF3 may be located above the active region AR of the fifth pixel PX5 of the second pixel group PG2, and the selection gate electrode SEL may be located above the active region AR of the sixth pixel PX6 of the fourth pixel group PG4.

The active region AR of the first pixel PX1 of the first pixel group PG1 and the active region AR of the second pixel PX2 of the third pixel group PG3 may be integrally formed (e.g., e.g., a single continuous structure with no grain boundary therebetween) by being connected to each other through a first connection portion CP1. The first connection portion CP1 between the active region AR of the first pixel PX1 of the first pixel group PG1 and the active region AR of the second pixel PX2 of the third pixel group PG3 may not overlap with the pixel separation structure DTI along the third direction DR3, which is the height direction.

For example, the pixel separation structure DTI may not be formed in the region corresponding to the first connection portion CP1.

The active region AR of the fourth pixel PX4 of the first pixel group PG1, the active region AR of the third pixel PX3 of the third pixel group PG3, the active region AR of the fifth pixel PX5 of the second pixel group PG2 and the active region AR of the sixth pixel PX6 of the fourth pixel group PG4 may be integrally formed by being connected to each other through a second connection portion CP2.

For example, the pixel separation structure DTI may not be formed in the region corresponding to the second connection portion CP2.

The first reset gate electrode RG1 and the active region AR of the first pixel PX1 of the first pixel group PG1 may form a first reset transistor RX1, and the second reset gate electrode RG2 and the active region AR of the second pixel PX2 of the third pixel group PG3 may form a second reset transistor RX2.

The active region AR of the first pixel PX1 of the first pixel group PG1 and the active region AR of the second pixel PX2 of the third pixel group PG3 that absorbs and detects light of a color different from the first pixel group PG1 may be integrally formed by being connected to each other through the first connection portion CP1, and accordingly, the first reset transistor RX1 and the second reset transistor RX2 may be directly connected without relying on the plurality of vias ML1 and the plurality of wire layers ML2 and ML3 of the first structure 300.

The reset transistor RX1 and RX2 of the image sensor 1000 according to an embodiment may include the first reset transistor RX1 and the second reset transistor RX2 that are directly connected without an additional wire layer, and accordingly, the performance of the reset transistor RX1 and RX2 may be raised without widening the area of the region occupied by the reset transistor RX1 and RX2. For example, the first reset transistor RX1 may be directly connected to the second reset transistor RX2 by a direct connection at a direct connection portion (e.g., connection portion such as CP1) at a particular vertical level. For example, the active region of the first reset transistor RX1 may be directly connected to the active region of the second reset transistor RX2 at the level at which the active region is formed, without any wiring or metal layer (at that level or other levels) connected therebetween at the direct connection portion.

Similarly, the first source follower gate electrode SF1 and the active region AR of the fourth pixel PX4 of the first pixel group PG1 may form a first source follower transistor S1, the second source follower gate electrode SF2 and the active region AR of the third pixel PX3 of the third pixel group PG3 may form a second source follower transistor S2, the third source follower gate electrode SF3 and the active region AR of the sixth pixel PX6 of the fourth pixel group PG4 may form a third source follower transistor S3, and the selection gate electrode SEL and the active region AR of the fifth pixel PX5 of the second pixel group PG2 may form the selection transistor SE.

The active region AR of the fourth pixel PX4 of the first pixel group PG1, the active region AR of the third pixel PX3 of the third pixel group PG3 configured to absorb and detect light of a color different from the first pixel group PG1, the active region AR of the fifth pixel PX5 of the second pixel group PG2 configured to absorb and detect light of a color different from the first pixel group PG1 and the active region AR of the sixth pixel PX6 of the fourth pixel group PG4 that absorbs and detects light of a color different from the second pixel group PG2 may be integrally formed by being connected to each other through the second connection portion CP2, and accordingly, the first source follower transistor S1, the second source follower transistor S2, the third source follower transistor S3, and the selection transistor SE may be directly connected without relying on the plurality of vias ML1 and the plurality of wire layers ML2 and ML3 of the first structure 300.

The source follower transistors S1, S2, and S3 of the image sensor 1000 according to an embodiment may include the first source follower transistor S1, the second source follower transistor S2 and the third source follower transistor S3 that are directly connected without an additional wire layer (e.g., as discussed above, they may have active regions at a particular vertical level that are directly connected to each other).

The source follower transistor may be the most sensitive to the intrinsic thermal noise and flicker noise of transistor elements, compared to other transistors, for example, the transmission transistor, reset transistor, and selection transistor.

The noise induced in the source follower transistor is transferred directly to the internal circuit, resulting in deteriorated image quality. As a source follower transistor may include the first source follower transistor S1, the second source follower transistor S2 and the third source follower transistor S3 (e.g., combined to form one transistor), the influence of the intrinsic thermal noise and flicker noise of transistor elements may be reduced, and the current amount during the operation of the source follower transistor may be increased.

Therefore, the linearity of the voltage-current graph of the source follower transistor may improve, and the noise from the source follower transistor may decrease.

The first source follower transistor S1, the second source follower transistor S2 and the third source follower transistor S3 of the source follower transistors S1, S2, and S3 may be directly connected without an additional wire layer, and accordingly, unnecessary coupling or resistance due to an additional wire layer may be prevented. In addition, the performance of the source follower transistors S1, S2, and S3 may be raised without widening the area of the region occupied by the source follower transistors S1, S2, and S3.

The source follower transistors S1, S2, and S3 and the selection transistor SE may also be directly connected without an additional wire layer, and unnecessary coupling or resistance due to an additional wire layer may be prevented.

One of a first gate electrode GE1 located above the active region AR of the seventh pixel PX7 of the second pixel group PG2 and a second gate electrode GE2 located above the active region AR of the eighth pixel PX8 of the second pixel group PG2 may be a dual conversion gate electrode DCG.

In addition, a gate electrode may not be located in one of the seventh pixel PX7 and the eighth pixel PX8 of the second pixel group PG2, and the active region that does not overlap with the gate electrode may be a ground region (not shown).

In the image sensor 1000 according to an embodiment, the transistors RX1, RX2, S1, S2, S3, SE, and DCX, formed by the plurality of gates RG1, RG2, SF1, SF2, SF3, SEL, GE1 and GE2 and the active regions AR, may have a fingered type structure that includes one source region and two drain regions. Therefore, the transistors RX1, RX2, S1, S2, S3, SE, and DCX may operate in a manner similar to two transistors connected in a parallel structure, and accordingly, the performance of the transistors RX1, RX2, S1, S2, S3, SE, and DCX may be raised without widening the area of the region occupied by the transistors RX1, RX2, S1, S2, S3, SE, and DCX.

As described above, one pixel region including two pixel groups share the reset transistor RX1 and RX2, the dual conversion transistor DCX, the source follower transistors S1 to S3, and the selection transistor SE, and accordingly, transistors for driving the image sensor may be efficiently disposed even if the size of the image sensor is decreased.

The locations of the source follower transistors S1 to S3, the selection transistor SE, the reset transistor RX1 and RX2, and the dual conversion transistor DCX are not limited to the locations depicted in FIGS. 4 and 5, and the locations of the source follower transistors S1 to S3, the selection transistor SE, the reset transistor RX1 and RX2, and the dual conversion transistor DCX may be changed in various ways, such that the plurality of pixels PX1, PX2, PX3, PX4, PX5, PX6, PX7, and PX8 may share the source follower transistors S1 to S3, the selection transistor SE, the reset transistor RX1 and RX2, and the dual conversion transistor DCX.

Referring to FIG. 6 and FIG. 7, the pixel separation structure DTI of the arrangement of the image sensor 1000 according to an embodiment will be described in further detail. FIG. 6 and FIG. 7 may refer to a different view of the same embodiment as FIG. 4 and FIG. 5.

The pixel separation structure DTI may surround at least a portion of the edge of each of the first pixel PX1, the second pixel PX2, the third pixel PX3 and the fourth pixel PX4 of the first pixel group PG1, and may surround at least a portion of the edge of each of the fifth pixel PX5, the sixth pixel PX6, the seventh pixel PX7 and the eighth pixel PX8 of the second pixel group PG2.

The first floating diffusion region FD1 may be located in a portion of each of the first pixel PX1, the second pixel PX2, the third pixel PX3, the fourth pixel PX4 of the first pixel group PG1, and the first floating diffusion region FD1 of each of the first pixel PX1, the second pixel PX2, the third pixel PX3, and the fourth pixel PX4 may be integrally formed.

The pixel separation structure DTI may have a first open portion OPN1 formed (e.g., may be omitted) in a region corresponding to the first floating diffusion region FD1 shared by the first pixel PX1, the second pixel PX2, the third pixel PX3, the fourth pixel PX4, and the first floating diffusion region FD1 may not overlap with the pixel separation structure DTI along the third direction DR3, which is the height direction.

The second floating diffusion region FD2 may be located in a portion of each of the fifth pixel PX5, the sixth pixel PX6, the seventh pixel PX7, the eighth pixel PX8 of the second pixel group PG2, and the second floating diffusion region FD2 of each of the fifth pixel PX5, the sixth pixel PX6, the seventh pixel PX7, the eighth pixel PX8 may be integrally formed.

The pixel separation structure DTI may have a second open portion OPN2 formed (e.g., may be omitted) in a region corresponding to the second floating diffusion region FD2 shared by the fifth pixel PX5, the sixth pixel PX6, the seventh pixel PX7, the eighth pixel PX8, and the second floating diffusion region FD2 may not overlap with the pixel separation structure DTI along the third direction DR3, which is the height direction.

Through the region corresponding to the first open portion OPN1 and the second open portion OPN2 of the pixel separation structure DTI, the first floating diffusion region FD1 shared by the first pixel PX1, the second pixel PX2, the third pixel PX3, the fourth pixel PX4 and the second floating diffusion region FD2 shared by the fifth pixel PX5, the sixth pixel PX6, the seventh pixel PX7, the eighth pixel PX8 are integrally formed to be adjacent to the first surface SFA of the substrate 200, such that the first floating diffusion region FD1 of the first pixel PX1, the second pixel PX2, the third pixel PX3, and the fourth pixel PX4 may be connected to each other without an additional wire layer for connection, and the second floating diffusion region FD2 of the fifth pixel PX5, the sixth pixel PX6, the seventh pixel PX7, and the eighth pixel PX8 may be similarly connected to each other.

The active region AR of the first pixel PX1 of the first pixel group PG1 and the active region AR of the second pixel PX2 of the third pixel group PG3 configured to absorb and detect light of a color different from the first pixel group PG1 may be integrally formed by being connected to each other through the first connection portion CP1.

The pixel separation structure DTI may have a third open portion OPN3 formed (e.g., may be omitted) in a region corresponding to the first connection portion CP1 between the active region AR of the first pixel PX1 of the first pixel group PG1 and the active region AR of the second pixel PX2 of the third pixel group PG3, and the first connection portion CP1 may not overlap with the pixel separation structure DTI along the third direction DR3, which is the height direction.

The active region AR of the fourth pixel PX4 of the first pixel group PG1, the active region AR of the third pixel PX3 of the third pixel group PG3 configured to absorb and detect light of a color different from the first pixel group PG1, the active region AR of the fifth pixel PX5 of the second pixel group PG2 configured to absorb and detect light of a color different from the first pixel group PG1 and the active region AR of the sixth pixel PX6 of the fourth pixel group PG4 configured to absorb and detect light of a color different from the second pixel group PG2 may be integrally formed by being connected to each other through the second connection portion CP2.

The pixel separation structure DTI may have a fourth open portion OPN4 formed (e.g., may be omitted) in a region corresponding to the second connection portion CP2 between the active region AR of the fourth pixel PX4 of the first pixel group PG1, the active region AR of the third pixel PX3 of the third pixel group PG3, the active region AR of the fifth pixel PX5 of the second pixel group PG2, and the active region AR of the sixth pixel PX6 of the fourth pixel group PG4, and the second connection portion CP2 may not overlap with the pixel separation structure DTI along the third direction DR3, which is the height direction.

Through the first connection portion CP1 located in a region corresponding to the third open portion OPN3 of the pixel separation structure DTI, the active region AR of the first pixel PX1 of the first pixel group PG1 and the active region AR of the second pixel PX2 of the third pixel group PG3 are connected to each other to be integrally formed to be adjacent to the first surface SFA of the substrate 200 (e.g., to be integrally formed at a vertical level adjacent to the first surface SFA of the substrate 200), and accordingly, the first reset transistor RX1 and the second reset transistor RX2 may be directly connected to each other without an additional wire layer for connection.

Through the second connection portion CP2 located in a region corresponding to the fourth open portion OPN4 of the pixel separation structure DTI, the active region AR of the fourth pixel PX4 of the first pixel group PG1, the active region AR of the third pixel PX3 of the third pixel group PG3, the active region AR of the fifth pixel PX5 of the second pixel group PG2 and the active region AR of the sixth pixel PX6 of the fourth pixel group PG4 are connected to each other to be integrally formed to be adjacent to the first surface SFA of the substrate 200 (e.g., to be integrally formed at a vertical level adjacent to the first surface SFA of the substrate 200), and accordingly, the first source follower transistor S1, the second source follower transistor S2, the third source follower transistor S3, and the selection transistor SE may be directly connected to each other without an additional wire layer for connection.

In addition, the pixel separation structure DTI surrounding edges of the plurality of pixels PX1, PX2, PX3, PX4, PX5, PX6, PX7, and PX8 of the first pixel group PG1 and the second pixel group PG2 may have the first open portion OPN1 located in a central portion of the first pixel group PG1, the second open portion OPN2 located in a central portion of the second pixel group PG2, and the third open portion OPN3 and the fourth open portion OPN4 located on edges of the first pixel group PG1 and the second pixel group PG2, and accordingly, the form of the pixel separation structure DTI, being symmetric, may ensure that the pixel separation structure DTI may be stably formed and maintained, thereby preventing the pixel separation structure DTI from tilting in any one direction.

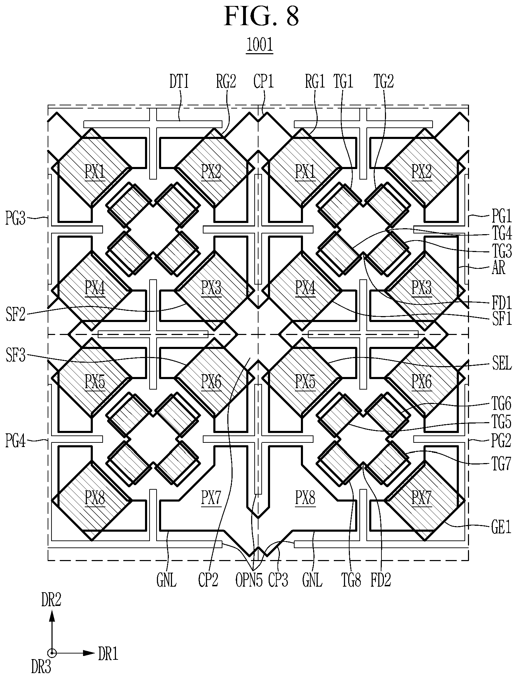

Referring to FIG. 8, an image sensor 1001 according to another embodiment will be described. FIG. 8 is a top plan view of an image sensor according to another embodiment.

Referring to FIG. 8, the image sensor 1001 according to the present embodiment is similar to the image sensor 1000 according to an embodiment described above. Detailed description on the same configuration elements is omitted.

The image sensor 1001 may further include the third pixel group PG3 and the fourth pixel group PG4 adjacent to the first pixel group PG1 and the second pixel group PG2 along the first direction DR1.

The first pixel PX1, the second pixel PX2, the third pixel PX3, and the fourth pixel PX4 of the first pixel group PG1 may share the first floating diffusion region FD1.

The first floating diffusion region FD1 may be located in a portion of each of the first pixel PX1, the second pixel PX2, the third pixel PX3, the fourth pixel PX4 of the first pixel group PG1, and the first floating diffusion region FD1 of each of the first pixel PX1, the second pixel PX2, the third pixel PX3, and the fourth pixel PX4 may be integrally formed.

The pixel separation structure DTI may have the first open portion OPN1 (as labeled in FIG. 6) formed in the region corresponding to the first floating diffusion region FD1 shared by the first pixel PX1, the second pixel PX2, the third pixel PX3, the fourth pixel PX4, and the first floating diffusion region FD1 may not overlap with the pixel separation structure DTI along the third direction DR3, which is the height direction.

The fifth pixel PX5, the sixth pixel PX6, the seventh pixel PX7, and the eighth pixel PX8 of the second pixel group PG2 may share the second floating diffusion region FD2.

The second floating diffusion region FD2 may be located in a portion of each of the fifth pixel PX5, the sixth pixel PX6, the seventh pixel PX7, the eighth pixel PX8 of the second pixel group PG2, and the second floating diffusion region FD2 of each of the fifth pixel PX5, the sixth pixel PX6, the seventh pixel PX7, the eighth pixel PX8 may be integrally formed.

The pixel separation structure DTI may have the second open portion OPN2 (as labeled in FIG. 6) formed in the region corresponding to the second floating diffusion region FD2 shared by the fifth pixel PX5, the sixth pixel PX6, the seventh pixel PX7, the eighth pixel PX8, and the second floating diffusion region FD2 may not overlap with the pixel separation structure DTI along the third direction DR3, which is the height direction.

The active region AR of the first pixel PX1 of the first pixel group PG1 and the active region AR of the second pixel PX2 of the third pixel group PG3 configured to absorb and detect light of a color different from the first pixel group PG1 may be integrally formed by being connected to each other through the first connection portion CP1.

The pixel separation structure DTI may have the third open portion OPN3 (as labeled in FIG. 6) formed in the region corresponding to the first connection portion CP1 between the active region AR of the first pixel PX1 of the first pixel group PG1 and the active region AR of the second pixel PX2 of the third pixel group PG3, and the first connection portion CP1 may not overlap with the pixel separation structure DTI along the third direction DR3, which is the height direction.

The active region AR of the fourth pixel PX4 of the first pixel group PG1, the active region AR of the third pixel PX3 of the third pixel group PG3 configured to absorb and detect light of a color different from the first pixel group PG1, the active region AR of the fifth pixel PX5 of the second pixel group PG2 configured to absorb and detect light of a color different from the first pixel group PG1 and the active region AR of the sixth pixel PX6 of the fourth pixel group PG4 configured to absorb and detect light of a color different from the second pixel group PG2 may be integrally formed by being connected to each other through the second connection portion CP2.

The pixel separation structure DTI may have the fourth open portion OPN4 (as labeled in FIG. 6) formed in the region corresponding to the second connection portion CP2 between the active region AR of the fourth pixel PX4 of the first pixel group PG1, the active region AR of the third pixel PX3 of the third pixel group PG3, the active region AR of the fifth pixel PX5 of the second pixel group PG2 and the active region AR of the sixth pixel PX6 of the fourth pixel group PG4, and the second connection portion CP2 may not overlap with the pixel separation structure DTI along the third direction DR3, which is the height direction.

In the image sensor 1001 according to the present embodiment, a ground region GNL of the eighth pixel PX8 of the second pixel group PG2 and the ground region GNL of the seventh pixel PX7 of the fourth pixel group PG4 that absorbs and detects light of a color different from the second pixel group PG2 may be connected to each other through a third connection portion CP3, and may be integrally formed to be adjacent to the first surface SFA of the substrate 200.

The pixel separation structure DTI may have a fifth open portion OPN5 formed in a region corresponding to the third connection portion CP3 between the ground region GNL of the eighth pixel PX8 of the second pixel group PG2 and the ground region GNL of the seventh pixel PX7 of the fourth pixel group PG4, and the third connection portion CP3 may not overlap with the pixel separation structure DTI along the third direction DR3, which is the height direction.

Through the third connection portion CP3 located in a region corresponding to the fifth open portion OPN5 of the pixel separation structure DTI, the ground region GNL of the eighth pixel PX8 of the second pixel group PG2 and the ground region GNL of the seventh pixel PX7 of the fourth pixel group PG4 may be connected to each other, and may be integrally formed to be adjacent to the first surface SFA of the substrate 200.

Various features of the image sensor 1000 according to an embodiment described above are all applicable to the image sensor 1001 according to the present embodiment.

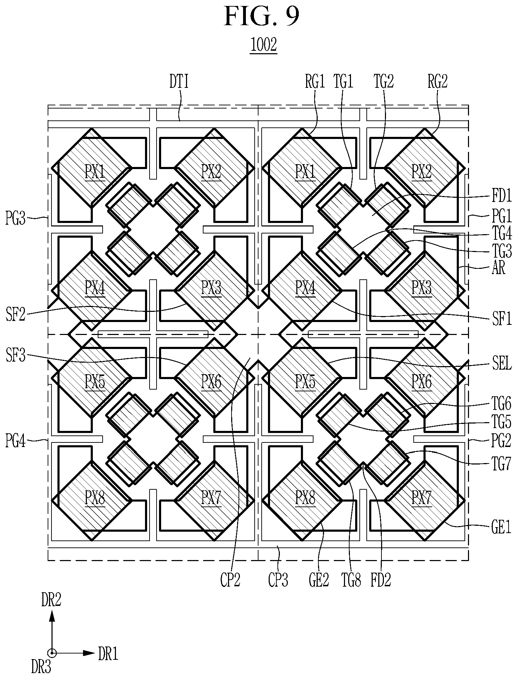

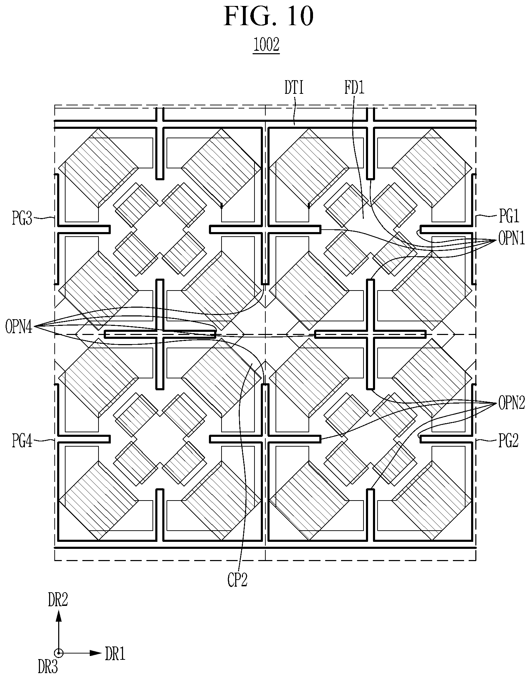

Referring to FIG. 9 and FIG. 10, an image sensor 1002 according to another embodiment will be described. FIG. 9 is a top plan view of an image sensor according to another embodiment. FIG. 10 is a top plan view showing pixel separation structure of an image sensor according to an embodiment.

Referring to FIG. 9, the image sensor 1002 according to the present embodiment is similar to the image sensors 1000 and 1001 according to embodiments described above. Detailed description on the same configuration elements is omitted.

The image sensor 1002 may further include the third pixel group PG3 and the fourth pixel group PG4 adjacent to the first pixel group PG1 and the second pixel group PG2 along the first direction DR1.

The first reset gate electrode RG1 may be located above the active region AR of the first pixel PX1 of the first pixel group PG1, and the second reset gate electrode RG2 may be located above the active region AR of the second pixel PX2 of the first pixel group PG1, and the first source follower gate electrode SF1 may be located above the active region AR of the fourth pixel PX4 of the first pixel group PG1.

The selection gate electrode SEL may be located above the active region AR of the fifth pixel PX5 of the second pixel group PG2.

The second source follower gate electrode SF2 adjacent to the first pixel group PG1 along the first direction DR1 may be located above the active region AR of the third pixel PX3 of the third pixel group PG3, and the third source follower gate electrode SF3 adjacent to the second pixel group PG2 may be located above the active region AR of the sixth pixel PX6 of the fourth pixel group PG4.

However, unlike this, according to another embodiment, the third source follower gate electrode SF3 may be located above the active region AR of the fifth pixel PX5 of the second pixel group PG2, and the selection gate electrode SEL may be located above the active region AR of the sixth pixel PX6 of the fourth pixel group PG4.

One of the first gate electrode GE1 located above the active region AR of the seventh pixel PX7 of the second pixel group PG2 and the second gate electrode GE2 located above the active region AR of the eighth pixel PX8 of the second pixel group PG2 may be the dual conversion gate electrode DCG.

In addition, a gate electrode may not be located in one of the seventh pixel PX7 and the eighth pixel PX8 of the second pixel group PG2, and the active region that does not overlap with the gate electrode may be a ground region (not shown).

The first pixel PX1, the second pixel PX2, the third pixel PX3, and the fourth pixel PX4 of the first pixel group PG1 may share the first floating diffusion region FD1.

The first floating diffusion region FD1 may be located in a portion of each of the first pixel PX1, the second pixel PX2, the third pixel PX3, the fourth pixel PX4 of the first pixel group PG1, and the first floating diffusion region FD1 of each of the first pixel PX1, the second pixel PX2, the third pixel PX3, and the fourth pixel PX4 may be integrally formed.

The fifth pixel PX5, the sixth pixel PX6, the seventh pixel PX7, and the eighth pixel PX8 of the second pixel group PG2 may share the second floating diffusion region FD2.

The second floating diffusion region FD2 may be located in a portion of each of the fifth pixel PX5, the sixth pixel PX6, the seventh pixel PX7, the eighth pixel PX8 of the second pixel group PG2, and the second floating diffusion region FD2 of each of the fifth pixel PX5, the sixth pixel PX6, the seventh pixel PX7, the eighth pixel PX8 may be integrally formed.

The active region AR of the fourth pixel PX4 of the first pixel group PG1, the active region AR of the third pixel PX3 of the third pixel group PG3 configured to absorb and detect light of a color different from the first pixel group PG1, the active region AR of the fifth pixel PX5 of the second pixel group PG2 configured to absorb and detect light of a color different from the first pixel group PG1 and the active region AR of the sixth pixel PX6 of the fourth pixel group PG4 that absorbs and detects light of a color different from the second pixel group PG2 may be integrally formed by being connected to each other through the second connection portion CP2, and accordingly, the first source follower transistor S1, the second source follower transistor S2, the third source follower transistor S3, and the selection transistor SE may be directly connected without relying on the plurality of vias ML1 and the plurality of wire layers ML2 and ML3 of the first structure 300.

The source follower transistors S1, S2, and S3 of the image sensor 1002 according to an embodiment may include the first source follower transistor S1, the second source follower transistor S2 and the third source follower transistor S3 that are directly connected without an additional wire layer.

The first source follower transistor S1, the second source follower transistor S2 and the third source follower transistor S3 of the source follower transistors S1, S2, and S3 may be directly connected without an additional wire layer, and accordingly, unnecessary coupling or resistance due to an additional wire layer may be prevented. In addition, the performance of the source follower transistors S1, S2, and S3 may be raised without widening the area of the region occupied by the source follower transistors S1, S2, and S3.

The source follower transistors S1, S2, and S3 and the selection transistor SE may also be directly connected without an additional wire layer, and unnecessary coupling or resistance due to an additional wire layer may be prevented.

Unlike the image sensors 1000 and 1001 according to embodiments described above, the first reset gate electrode RG1 and the second reset gate electrode RG2 of the image sensor 1002 according to the present embodiment may be located above the active regions AR of the first pixel PX1 and the second pixel PX2 of the first pixel group PG1, and the first reset transistor RX1 and the second reset transistor RX2 may not be directly connected.

Referring to FIG. 10, the pixel separation structure DTI of the image sensor 1002 according to the present embodiment may have the first open portion OPN1 formed in the region corresponding to the first floating diffusion region FD1 shared by the first pixel PX1, the second pixel PX2, the third pixel PX3, the fourth pixel PX4, and the first floating diffusion region FD1 may not overlap with the pixel separation structure DTI along the third direction DR3, which is the height direction.

The pixel separation structure DTI may have the second open portion OPN2 formed in the region corresponding to the second floating diffusion region FD2 shared by the fifth pixel PX5, the sixth pixel PX6, the seventh pixel PX7, the eighth pixel PX8, and the second floating diffusion region FD2 may not overlap with the pixel separation structure DTI along the third direction DR3, which is the height direction.

The pixel separation structure DTI may have the fourth open portion OPN4 formed in the region corresponding to the second connection portion CP2 between the active region AR of the fourth pixel PX4 of the first pixel group PG1, the active region AR of the third pixel PX3 of the third pixel group PG3, the active region AR of the fifth pixel PX5 of the second pixel group PG2 and the active region AR of the sixth pixel PX6 of the fourth pixel group PG4, and the second connection portion CP2 may not overlap with the pixel separation structure DTI along the third direction DR3, which is the height direction.

Unlike the image sensors 1000 and 1001 according to embodiments described above, the pixel separation structure DTI of the image sensor 1002 according to the present embodiment may not have the third open portion OPN3.

Therefore, the pixel separation structure DTI may be stably formed and maintained, thereby preventing the pixel separation structure DTI from tilting in any one direction.

Various features of the image sensors 1000 and 1001 according to embodiments described above are all applicable to the image sensor 1002 according to the present embodiment.

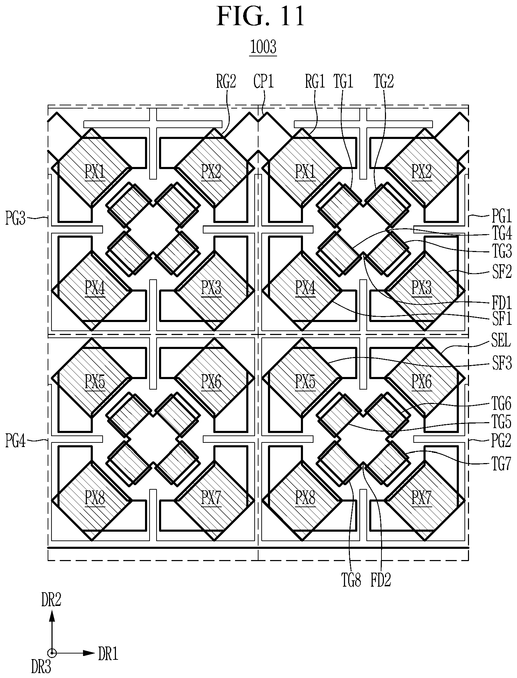

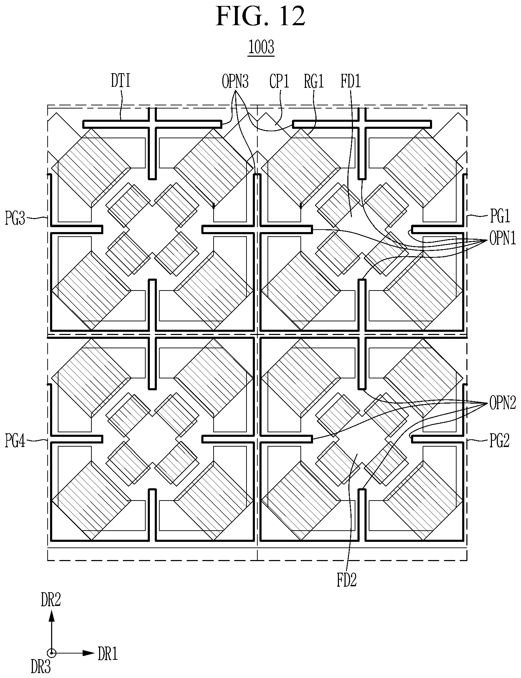

Referring to FIG. 11 and FIG. 12, an image sensor 1003 according to another embodiment will be described. FIG. 11 is a top plan view of an image sensor according to another embodiment. FIG. 12 is a top plan view showing pixel separation structure of an image sensor according to another embodiment.

Referring to FIG. 11, the image sensor 1003 according to the present embodiment is similar to the image sensors 1000, 1001, and 1002 according to embodiments described above. Detailed description on the same configuration element is omitted.

The image sensor 1003 may further include the third pixel group PG3 and the fourth pixel group PG4 adjacent to the first pixel group PG1 and the second pixel group PG2 along the first direction DR1.

The first reset gate electrode RG1 may be located above the active region AR of the first pixel PX1 of the first pixel group PG1, and may be adjacent to the first pixel group PG1 along the first direction DR1, and the second reset gate electrode RG2 configured to absorb and detect light of a color different from the first pixel group PG1 may be located above the active region AR of the second pixel PX2 of the third pixel group PG3.

The first source follower gate electrode SF1 may be located above the active region AR of the fourth pixel PX4 of the first pixel group PG1, and the second source follower gate electrode SF2 may be located above the active region AR of the third pixel PX3 of the first pixel group PG1.

The third source follower gate electrode SF3 may be located above the active region AR of the fifth pixel PX5 of the second pixel group PG2, and the selection gate electrode SEL may be located above the active region AR of the sixth pixel PX6 of the second pixel group PG2.

One of the first gate electrode GE1 located above the active region AR of the seventh pixel PX7 of the second pixel group PG2 and the second gate electrode GE2 located above the active region AR of the eighth pixel PX8 of the second pixel group PG2 may be the dual conversion gate electrode DCG.

In addition, a gate electrode may not be located in one of the seventh pixel PX7 and the eighth pixel PX8 of the second pixel group PG2, and the active region that does not overlap with the gate electrode may be a ground region (not shown).

The first pixel PX1, the second pixel PX2, the third pixel PX3, and the fourth pixel PX4 of the first pixel group PG1 may share the first floating diffusion region FD1.

The first floating diffusion region FD1 may be located in a portion of each of the first pixel PX1, the second pixel PX2, the third pixel PX3, the fourth pixel PX4 of the first pixel group PG1, and the first floating diffusion region FD1 of each of the first pixel PX1, the second pixel PX2, the third pixel PX3, and the fourth pixel PX4 may be integrally formed.

The fifth pixel PX5, the sixth pixel PX6, the seventh pixel PX7, and the eighth pixel PX8 of the second pixel group PG2 may share the second floating diffusion region FD2.

The second floating diffusion region FD2 may be located in a portion of each of the fifth pixel PX5, the sixth pixel PX6, the seventh pixel PX7, the eighth pixel PX8 of the second pixel group PG2, and the second floating diffusion region FD2 of each of the fifth pixel PX5, the sixth pixel PX6, the seventh pixel PX7, the eighth pixel PX8 may be integrally formed.

The active region AR of the first pixel PX1 of the first pixel group PG1 and the active region AR of the second pixel PX2 of the third pixel group PG3 may be integrally formed by being connected to each other through the first connection portion CP1. The first connection portion CP1 between the active region AR of the first pixel PX1 of the first pixel group PG1 and the active region AR of the second pixel PX2 of the third pixel group PG3 may not overlap with the pixel separation structure DTI along the third direction DR3, which is the height direction.

Referring to FIG. 12, the pixel separation structure DTI of the image sensor 1003 according to the present embodiment may have the first open portion OPN1 formed in the region corresponding to the first floating diffusion region FD1 shared by the first pixel PX1, the second pixel PX2, the third pixel PX3, the fourth pixel PX4, and the first floating diffusion region FD1 may not overlap with the pixel separation structure DTI along the third direction DR3, which is the height direction.

The pixel separation structure DTI may have the second open portion OPN2 formed in the region corresponding to the second floating diffusion region FD2 shared by the fifth pixel PX5, the sixth pixel PX6, the seventh pixel PX7, the eighth pixel PX8, and the second floating diffusion region FD2 may not overlap with the pixel separation structure DTI along the third direction DR3, which is the height direction.

The pixel separation structure DTI may have the third open portion OPN3 formed in the region corresponding to the first connection portion CP1 between the active region AR of the first pixel PX1 of the first pixel group PG1 and the active region AR of the second pixel PX2 of the third pixel group PG3, and the first connection portion CP1 may not overlap with the pixel separation structure DTI along the third direction DR3, which is the height direction.

Unlike the image sensors 1000, 1001, and 1002 according to embodiments described above, the pixel separation structure DTI of the image sensor 1002 according to the present embodiment may not have the fourth open portion OPN4.

Therefore, the pixel separation structure DTI may be stably formed and maintained, thereby preventing the pixel separation structure DTI from tilting in any one direction.

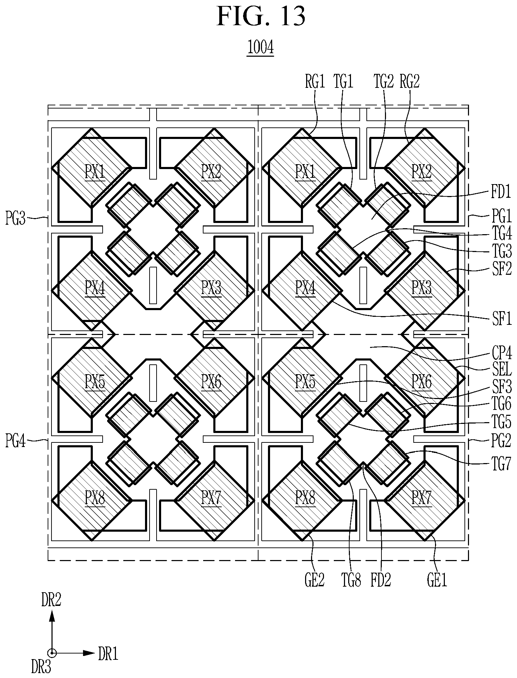

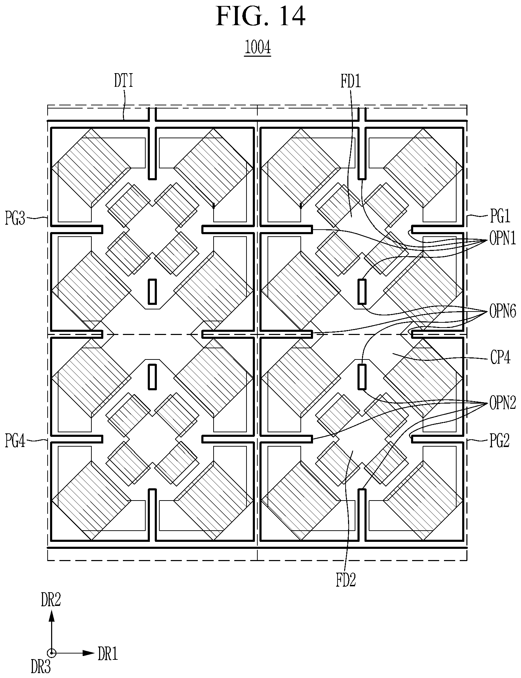

Referring to FIG. 13 and FIG. 14, an image sensor 1004 according to another embodiment will be described. FIG. 13 is a top plan view of an image sensor according to another embodiment. FIG. 14 is a top plan view showing pixel separation structure of an image sensor according to another embodiment.

Referring to FIG. 13, the image sensor 1004 is similar to the image sensors 1000, 1001, 1002, and 1003 according to embodiments described above. Detailed description on the same configuration elements is omitted.

The image sensor 1004 may further include the third pixel group PG3 and the fourth pixel group PG4 adjacent to the first pixel group PG1 and the second pixel group PG2 along the first direction DR1.

The first reset gate electrode RG1 may be located above the active region AR of the first pixel PX1 of the first pixel group PG1, and the second reset gate electrode RG2 may be located above the active region AR of the second pixel PX2 of the first pixel group PG1.

The first source follower gate electrode SF1 may be located above the active region AR of the fourth pixel PX4 of the first pixel group PG1, and the second source follower gate electrode SF2 may be located above the active region AR of the third pixel PX3 of the first pixel group PG1.

The third source follower gate electrode SF3 may be located above the active region AR of the fifth pixel PX5 of the second pixel group PG2, and the selection gate electrode SEL may be located above the active region AR of the sixth pixel PX6 of the second pixel group PG2.

One of the first gate electrode GE1 located above the active region AR of the seventh pixel PX7 of the second pixel group PG2 and the second gate electrode GE2 located above the active region AR of the eighth pixel PX8 of the second pixel group PG2 may be the dual conversion gate electrode DCG.

In addition, a gate electrode may not be located in one of the seventh pixel PX7 and the eighth pixel PX8 of the second pixel group PG2, and the active region that does not overlap with the gate electrode may be a ground region (not shown).

The first pixel PX1, the second pixel PX2, the third pixel PX3, and the fourth pixel PX4 of the first pixel group PG1 may share the first floating diffusion region FD1.

The first floating diffusion region FD1 may be located in a portion of each of the first pixel PX1, the second pixel PX2, the third pixel PX3, the fourth pixel PX4 of the first pixel group PG1, and the first floating diffusion region FD1 of each of the first pixel PX1, the second pixel PX2, the third pixel PX3, and the fourth pixel PX4 may be integrally formed.

The fifth pixel PX5, the sixth pixel PX6, the seventh pixel PX7, and the eighth pixel PX8 of the second pixel group PG2 may share the second floating diffusion region FD2.

The second floating diffusion region FD2 may be located in a portion of each of the fifth pixel PX5, the sixth pixel PX6, the seventh pixel PX7, the eighth pixel PX8 of the second pixel group PG2, and the second floating diffusion region FD2 of each of the fifth pixel PX5, the sixth pixel PX6, the seventh pixel PX7, the eighth pixel PX8 may be integrally formed.

A fourth connection portion CP4 between the active region AR of the third pixel PX3 of the first pixel group PG1, the active region AR of the fourth pixel PX4 of the first pixel group PG1, the active region AR of the fifth pixel PX5 of the second pixel group PG2, and the active region AR of the sixth pixel PX6 of the second pixel group PG2 may not overlap with the pixel separation structure DTI along the third direction DR3, which is the height direction.

The active region AR of the third pixel PX3 of the first pixel group PG1, the active region AR of the fourth pixel PX4 of the first pixel group PG1, the active region AR of the fifth pixel PX5 of the second pixel group PG2, the active region AR of the sixth pixel PX6 of the second pixel group PG2 that absorbs and detects light of a color different from the first pixel group PG1 may be integrally formed by being connected to each other through the fourth connection portion CP4, and accordingly, the first source follower transistor S1, the second source follower transistor S2, the third source follower transistor S3, and the selection transistor SE may be directly connected without relying on an additional wire.

The source follower transistors S1, S2, and S3 of the image sensor 1004 according to an embodiment may include the first source follower transistor S1, the second source follower transistor S2 and the third source follower transistor S3 that are directly connected without an additional wire layer.

The first source follower transistor S1, the second source follower transistor S2 and the third source follower transistor S3 of the source follower transistors S1, S2, and S3 may be directly connected without an additional wire layer, and accordingly, unnecessary coupling or resistance due to an additional wire layer may be prevented. In addition, the performance of the source follower transistors S1, S2, and S3 may be raised without widening the area of the region occupied by the source follower transistors S1, S2, and S3.

The source follower transistors S1, S2, and S3 and the selection transistor SE may also be directly connected without an additional wire layer, and unnecessary coupling or resistance due to an additional wire layer may be prevented.

The first reset gate electrode RG1 and the second reset gate electrode RG2 of the image sensor 1004 according to the present embodiment may be located above the active regions AR of the first pixel PX1 and the second pixel PX2 of the first pixel group PG1, and the first reset transistor RX1 and the second reset transistor RX2 may not be directly connected.

Referring to FIG. 14, the pixel separation structure DTI of the image sensor 1004 according to the present embodiment may have the first open portion OPN1 formed in the region corresponding to the first floating diffusion region FD1 shared by the first pixel PX1, the second pixel PX2, the third pixel PX3, the fourth pixel PX4, and the first floating diffusion region FD1 may not overlap with the pixel separation structure DTI along the third direction DR3, which is the height direction.

The pixel separation structure DTI may have the second open portion OPN2 formed in the region corresponding to the second floating diffusion region FD2 shared by the fifth pixel PX5, the sixth pixel PX6, the seventh pixel PX7, the eighth pixel PX8, and the second floating diffusion region FD2 may not overlap with the pixel separation structure DTI along the third direction DR3, which is the height direction.

The pixel separation structure DTI may have a sixth open portion OPN6 formed in a region corresponding to the fourth connection portion CP4 between the active region AR of the third pixel PX3 of the first pixel group PG1, the active region AR of the fourth pixel PX4 of the first pixel group PG1, the active region AR of the fifth pixel PX5 of the second pixel group PG2 configured to absorb and detect light of a color different from the first pixel group PG1 and the active region AR of the sixth pixel PX6 of the second pixel group PG2, and the fourth connection portion CP4 may not overlap with the pixel separation structure DTI along the third direction DR3, which is the height direction.

The pixel separation structure DTI of the image sensor 1004 according to the present embodiment may not have the third open portion OPN3. Therefore, the pixel separation structure DTI may be stably formed and maintained, thereby preventing the pixel separation structure DTI from tilting in any one direction.

Various features of the image sensors 1000, 1001, 1002, and 1003 according to embodiments described above are all applicable to the image sensor 1004 according to the present embodiment.

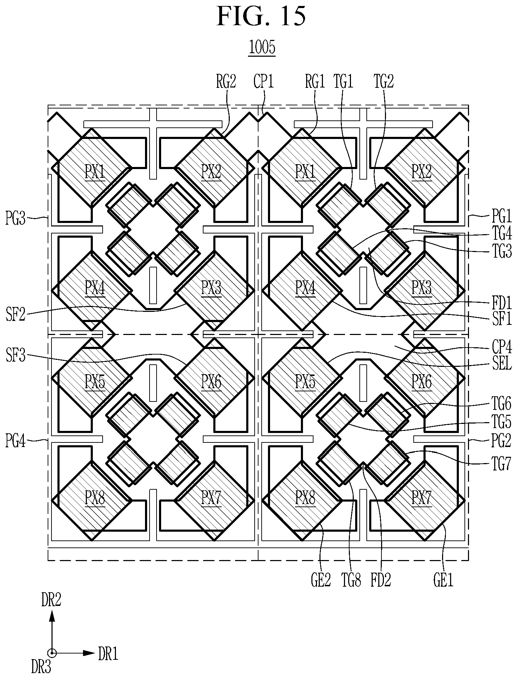

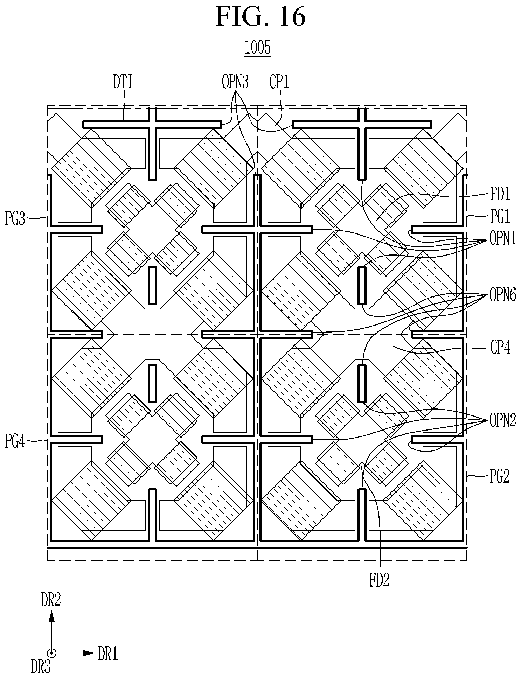

Referring to FIG. 15 and FIG. 16, an image sensor 1005 according to another embodiment will be described. FIG. 15 is a top plan view of an image sensor according to another embodiment. FIG. 16 is a top plan view showing pixel separation structure of an image sensor according to another embodiment.

Referring to FIG. 15, the image sensor 1005 according to the present embodiment is similar to the image sensors 1000, 1001, 1002, 1003, and 1004 according to embodiments described above. Detailed description on the same configuration elements is omitted.

The image sensor 1005 may further include the third pixel group PG3 and the fourth pixel group PG4 adjacent to the first pixel group PG1 and the second pixel group PG2 along the first direction DR1.

The first reset gate electrode RG1 may be located above the active region AR of the first pixel PX1 of the first pixel group PG1, and may be adjacent to the first pixel group PG1 along the first direction DR1, and the second reset gate electrode RG2 configured to absorb and detect light of a color different from the first pixel group PG1 may be located above the active region AR of the second pixel PX2 of the third pixel group PG3.

The first source follower gate electrode SF1 may be located above the active region AR of the fourth pixel PX4 of the first pixel group PG1, and the second source follower gate electrode SF2 may be located above the active region AR of the third pixel PX3 of the first pixel group PG1.

The third source follower gate electrode SF3 may be located above the active region AR of the sixth pixel PX6 of the second pixel group PG2, and the selection gate electrode SEL may be located above the active region AR of the fifth pixel PX5 of the second pixel group PG2.

One of the first gate electrode GE1 located above the active region AR of the seventh pixel PX7 of the second pixel group PG2 and the second gate electrode GE2 located above the active region AR of the eighth pixel PX8 of the second pixel group PG2 may be the dual conversion gate electrode DCG.

In addition, a gate electrode may not be located in one of the seventh pixel PX7 and the eighth pixel PX8 of the second pixel group PG2, and the active region that does not overlap with the gate electrode may be a ground region (not shown).

The first pixel PX1, the second pixel PX2, the third pixel PX3, and the fourth pixel PX4 of the first pixel group PG1 may share the first floating diffusion region FD1.

The first floating diffusion region FD1 may be located in a portion of each of the first pixel PX1, the second pixel PX2, the third pixel PX3, the fourth pixel PX4 of the first pixel group PG1, and the first floating diffusion region FD1 of each of the first pixel PX1, the second pixel PX2, the third pixel PX3, and the fourth pixel PX4 may be integrally formed.

The fifth pixel PX5, the sixth pixel PX6, the seventh pixel PX7, and the eighth pixel PX8 of the second pixel group PG2 may share the second floating diffusion region FD2.

The second floating diffusion region FD2 may be located in a portion of each of the fifth pixel PX5, the sixth pixel PX6, the seventh pixel PX7, the eighth pixel PX8 of the second pixel group PG2, and the second floating diffusion region FD2 of each of the fifth pixel PX5, the sixth pixel PX6, the seventh pixel PX7, the eighth pixel PX8 may be integrally formed.

The active region AR of the first pixel PX1 of the first pixel group PG1 and the active region AR of the second pixel PX2 of the third pixel group PG3 may be integrally formed by being connected to each other through the first connection portion CP1. The first connection portion CP1 between the active region AR of the first pixel PX1 of the first pixel group PG1 and the active region AR of the second pixel PX2 of the third pixel group PG3 may not overlap with the pixel separation structure DTI along the third direction DR3, which is the height direction.

The active region AR of the third pixel PX3 of the first pixel group PG1, the active region AR of the fourth pixel PX4 of the first pixel group PG1, the active region AR of the fifth pixel PX5 of the second pixel group PG2 configured to absorb and detect light of a color different from the first pixel group PG1, and the active region AR of the sixth pixel PX6 of the second pixel group PG2 may be integrally formed by being connected to each other through the fourth connection portion CP4.

The fourth connection portion CP4 between the active region AR of the third pixel PX3 of the first pixel group PG1, the active region AR of the fourth pixel PX4 of the first pixel group PG1, the active region AR of the fifth pixel PX5 of the second pixel group PG2, and the active region AR of the sixth pixel PX6 of the second pixel group PG2 may not overlap with the pixel separation structure DTI along the third direction DR3, which is the height direction.

The active region AR of the first pixel PX1 of the first pixel group PG1 and the active region AR of the second pixel PX2 of the third pixel group PG3 that absorbs and detects light of a color different from the first pixel group PG1 may be integrally formed by being connected to each other through the first connection portion CP1, and accordingly, the first reset transistor RX1 and the second reset transistor RX2 may be directly connected without relying on the plurality of vias ML1 and the plurality of wire layers ML2 and ML3 of the first structure 300.

The active region AR of the third pixel PX3 of the first pixel group PG1, the active region AR of the fourth pixel PX4 of the first pixel group PG1, the active region AR of the fifth pixel PX5 of the second pixel group PG2 and the active region AR of the sixth pixel PX6 of the second pixel group PG2 that absorbs and detects light of a color different from the first pixel group PG1 may be integrally formed by being connected to each other through the fourth connection portion CP4, and accordingly, the first source follower transistor S1, the second source follower transistor S2, the third source follower transistor S3, and the selection transistor SE may be directly connected without relying on an additional wire.

The reset transistor RX1 and RX2 of the image sensor 1005 according to an embodiment may include the first reset transistor RX1 and the second reset transistor RX2 that are directly connected without an additional wire layer, and accordingly, the performance of the reset transistor RX1 and RX2 may be raised without widening the area of the region occupied by the reset transistor RX1 and RX2.

The source follower transistors S1, S2, and S3 may include the first source follower transistor S1, the second source follower transistor S2 and the third source follower transistor S3 that are directly connected without an additional wire layer.

The first source follower transistor S1, the second source follower transistor S2 and the third source follower transistor S3 of the source follower transistors S1, S2, and S3 may be directly connected without an additional wire layer, and accordingly, unnecessary coupling or resistance due to an additional wire layer may be prevented. In addition, the performance of the source follower transistors S1, S2, and S3 may be raised without widening the area of the region occupied by the source follower transistors S1, S2, and S3.

The source follower transistors S1, S2, and S3 and the selection transistor SE may also be directly connected without an additional wire layer, and unnecessary coupling or resistance due to an additional wire layer may be prevented.

Referring to FIG. 16, the pixel separation structure DTI of the image sensor 1005 according to the present embodiment may have the first open portion OPN1 formed in the region corresponding to the first floating diffusion region FD1 shared by the first pixel PX1, the second pixel PX2, the third pixel PX3, the fourth pixel PX4, and the first floating diffusion region FD1 may not overlap with the pixel separation structure DTI along the third direction DR3, which is the height direction.

The pixel separation structure DTI may have the second open portion OPN2 formed in the region corresponding to the second floating diffusion region FD2 shared by the fifth pixel PX5, the sixth pixel PX6, the seventh pixel PX7, the eighth pixel PX8, and the second floating diffusion region FD2 may not overlap with the pixel separation structure DTI along the third direction DR3, which is the height direction.

The pixel separation structure DTI may have the third open portion OPN3 formed in the region corresponding to the first connection portion CP1 between the active region AR of the first pixel PX1 of the first pixel group PG1 and the active region AR of the second pixel PX2 of the third pixel group PG3, and the first connection portion CP1 may not overlap with the pixel separation structure DTI along the third direction DR3, which is the height direction.

The pixel separation structure DTI may have the sixth open portion OPN6 formed in the region corresponding to the fourth connection portion CP4 between the active region AR of the third pixel PX3 of the first pixel group PG1, the active region AR of the fourth pixel PX4 of the first pixel group PG1, the active region AR of the fifth pixel PX5 of the second pixel group PG2 configured to absorb and detect light of a color different from the first pixel group PG1 and the active region AR of the sixth pixel PX6 of the second pixel group PG2, and the fourth connection portion CP4 may not overlap with the pixel separation structure DTI along the third direction DR3, which is the height direction.

Various features of the image sensors 1000, 1001, 1002, 1003, and 1004 according to embodiments described above are all applicable to the image sensor 1005 according to the present embodiment.

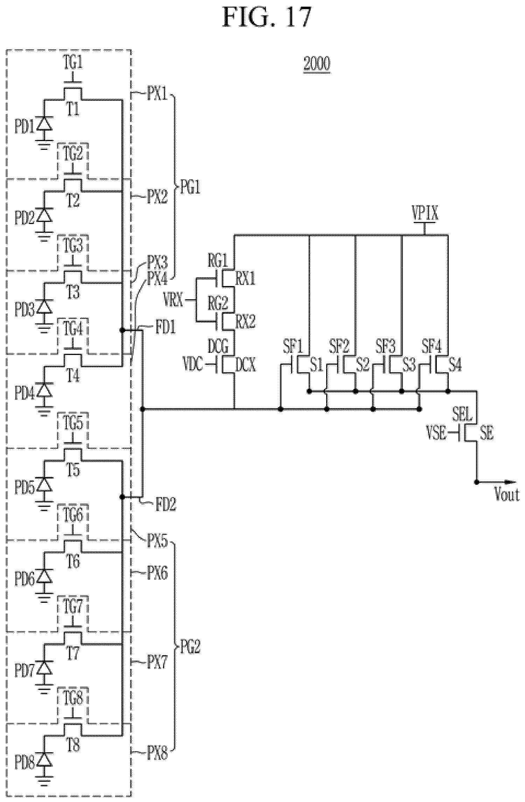

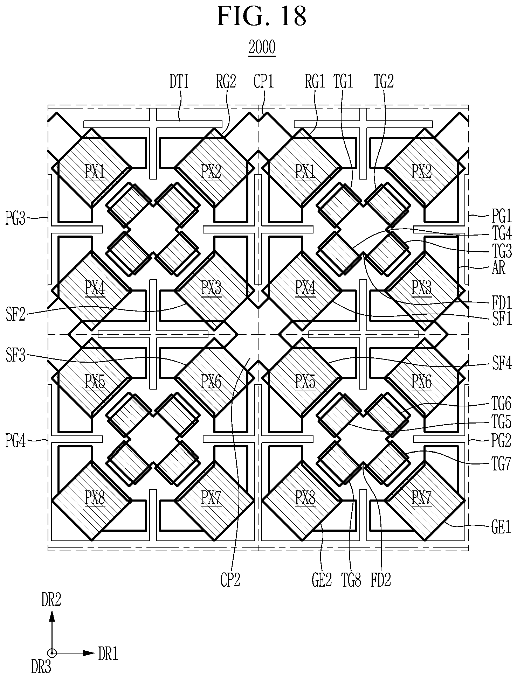

Referring to FIG. 17 and FIG. 18, an image sensor 2000 according to another embodiment will be described. FIG. 17 is a circuit diagram of an image sensor according to another embodiment. FIG. 18 is a top plan view of an image sensor according to another embodiment.

Referring to FIG. 17, the image sensor 2000 according to the present embodiment may include the first pixel group PG1 and the second pixel group PG2, and the first pixel group PG1 and the second pixel group PG2 may include pixels PX1 to PX8, the photoelectric conversion regions PD1 to PD8, the transmission transistors T1 to T8, the reset transistor RX1 and RX2, the dual conversion transistor DCX, source follower transistors S1 to S4, and the selection transistor SE. As described above, it is illustrated that, in each of the first pixel group PG1 and the second pixel group PG2, the four pixels PX1 to PX4 or PX5 to PX8 include the photoelectric conversion regions PD1 to PD4 or PD5 to PD8, respectively, but the embodiments are not limited thereto.

The first pixel PX1 may include the first photoelectric conversion region PD1 and the first transmission transistor T1, the second pixel PX2 may include the second photoelectric conversion region PD2 and the second transmission transistor T2, the third pixel PX3 may include the third photoelectric conversion region PD3 and the third transmission transistor T3, and the fourth pixel PX4 may include the fourth photoelectric conversion region PD4 and the fourth transmission transistor T4.

The fifth pixel PX5 may include the fifth photoelectric conversion region PD5 and the fifth transmission transistor T5, the sixth pixel PX6 may include the sixth photoelectric conversion region PD6 and the sixth transmission transistor T6, the seventh pixel PX7 may include the seventh photoelectric conversion region PD7 and the seventh transmission transistor T7, and the eighth pixel PX8 may include the eighth photoelectric conversion region PD8 and the eighth transmission transistor T8.

The pixels PX1 to PX4 of the first pixel group PG1 may share the first floating diffusion region FD1.

The pixels PX5 to PX8 of the second pixel group PG2 may share the second floating diffusion region FD2.

The first pixel group PG1 and the second pixel group PG2 may share the reset transistor RX1 and RX2, the dual conversion transistor DCX, the source follower transistors S1 to S4, and the selection transistor SE. The first floating diffusion region FD1 or the second floating diffusion region FD2 may accumulate charges corresponding to the amount of the incident light.

While the transmission transistors T1 to T8 are turned on by the transmission signals, respectively, the first floating diffusion region FD1 and the second floating diffusion region FD2 may accumulate charges provided from the photoelectric conversion regions PD1 to PD4 and the photoelectric conversion regions PD5 to PD8.

The reset transistor RX1 and RX2 may be driven by the reset signal, and may provide a power source voltage to the first floating diffusion region FD1 or the second floating diffusion region FD2. Accordingly, the charges accumulated in the first floating diffusion region FD1 or the expanded second floating diffusion region FD2 may move to the power source voltage VPIX, and the voltage of the first floating diffusion region FD1 or the second floating diffusion region FD2 may be reset.

Source follower transistors S1, S2, S3, and S4 may be connected between the power source voltage VPIX and the selection transistor SE. The source follower transistors S1, S2, S3, and S4 may output the output signal Vout to the selection transistor SE based on the voltage level of the first floating diffusion region FD1 or the second floating diffusion region FD2.

The dual conversion transistor DCX may be connected between the floating diffusion regions FD1 and FD2 and the reset transistors RX1 and RX2. When the dual conversion transistor DCX is turned off, the Full Well Capacity (FWC) of each of the pixels PX1 to PX8 may be the capacitance of the first floating diffusion region FD1 and the second floating diffusion region FD2. When the dual conversion transistor DCX is turned on, the FWC of each of the pixels PX1 to PX8 may increase to be greater than the capacitance of the first floating diffusion region FD1. According to turning on and off of the dual conversion transistor DCX, the conversion gain of each of the pixels PX1 to PX8 may be varied.

Unlike image sensors 1000, 1001, 1002, 1003, 1004, and 1005 according to embodiments described above, the image sensor 2000 according to the present embodiment may include four source follower transistors S1, S2, S3, and S4.

As the source follower transistor may include the first source follower transistor S1, the second source follower transistor S2, the third source follower transistor S3 and a fourth source follower transistor S4, the influence of the intrinsic thermal noise and flicker noise of the source follower transistor element may be reduced, and the current amount during the operation of the source follower transistor may be increased. Therefore, the linearity of the voltage-current graph of the source follower transistor may improve, and the noise from the source follower transistor may decrease.

Referring to FIG. 18, the image sensor 2000 according to the present embodiment is similar to the image sensor 1000 according to an embodiment shown in FIG. 4 to FIG. 7. Detailed description on the same configuration elements is omitted.

Referring to FIG. 18, the image sensor 2000 according to the present embodiment may further include the third pixel group PG3 and the fourth pixel group PG4 adjacent to the first pixel group PG1 and the second pixel group PG2 along the first direction DR1.

The first pixel PX1, the second pixel PX2, the third pixel PX3, and the fourth pixel PX4 of the first pixel group PG1 may share the first floating diffusion region FD1.

The first floating diffusion region FD1 may be located in a portion of each of the first pixel PX1, the second pixel PX2, the third pixel PX3, the fourth pixel PX4 of the first pixel group PG1, and the first floating diffusion region FD1 of each of the first pixel PX1, the second pixel PX2, the third pixel PX3, and the fourth pixel PX4 may be integrally formed.

The pixel separation structure DTI may be removed from the region corresponding to the first floating diffusion region FD1 shared by the first pixel PX1, the second pixel PX2, the third pixel PX3, the fourth pixel PX4, and accordingly, the pixel separation structure DTI may have as shown in FIG. 6, the first open portion OPN1, and the first floating diffusion region FD1 may not overlap with the pixel separation structure DTI along the third direction DR3, which is the height direction.

The first pixel PX1, the second pixel PX2, the third pixel PX3, and the fourth pixel PX4 of the first pixel group PG1 may include the first transmission gate electrode TG1, the second transmission gate electrode TG2, the third transmission gate electrode TG3, and the fourth transmission gate electrode TG4 located above the active region AR, and the first floating diffusion region FD1 may be formed in a portion of the active region AR, and located on a side of the first transmission gate electrode TG1, the second transmission gate electrode TG2, the third transmission gate electrode TG3, and the fourth transmission gate electrode TG4.

The fifth pixel PX5, the sixth pixel PX6, the seventh pixel PX7, and the eighth pixel PX8 of the second pixel group PG2 may share the second floating diffusion region FD2.

The second floating diffusion region FD2 may be located in a portion of each of the fifth pixel PX5, the sixth pixel PX6, the seventh pixel PX7, the eighth pixel PX8 of the second pixel group PG2, and the second floating diffusion region FD2 of each of the fifth pixel PX5, the sixth pixel PX6, the seventh pixel PX7, the eighth pixel PX8 may be integrally formed.

The pixel separation structure DTI may be removed from the region corresponding to the second floating diffusion region FD2 shared by the fifth pixel PX5, the sixth pixel PX6, the seventh pixel PX7, the eighth pixel PX8, and accordingly, the pixel separation structure DTI may have the second open portion OPN2, as shown in FIG. 6, and the second floating diffusion region FD2 may not overlap with the pixel separation structure DTI along the third direction DR3, which is the height direction.

The fifth pixel PX5, the sixth pixel PX6, the seventh pixel PX7, and the eighth pixel PX8 of the second pixel group PG2 may include the fifth transmission gate electrode TG5, the sixth transmission gate electrode TG6, the seventh transmission gate electrode TG7, and the eighth transmission gate electrode TG8 located above the active region AR, and the second floating diffusion region FD2 may be formed in a portion of the active region AR and may be located on a side of the fifth transmission gate electrode TG5, the sixth transmission gate electrode TG6, the seventh transmission gate electrode TG7, and the eighth transmission gate electrode TG8.

The first reset gate electrode RG1 may be located above the active region AR of the first pixel PX1 of the first pixel group PG1, and the second reset gate electrode RG2 may be located above the active region AR of the second pixel PX2 of the third pixel group PG3 disposed adjacent to the first pixel group PG1 along the first direction DR1 and configured to absorb and detect light of a color different from the first pixel group PG1.

The first source follower gate electrode SF1 may be located above the active region AR of the fourth pixel PX4 of the first pixel group PG1.

The second source follower gate electrode SF2 may be located above the active region AR of the third pixel PX3 of the third pixel group PG3 disposed adjacent to the first pixel group PG1 along the first direction DR1 and configured to absorb and detect light of a color different from the first pixel group PG1.

The third source follower gate electrode SF3 may be located above the active region AR of the sixth pixel PX6 of the fourth pixel group PG4 disposed adjacent to the second pixel group PG2 along the first direction DR1 and configured to absorb and detect light of a color different from the second pixel group PG2.

A fourth source follower gate electrode SF4 may be located above the active region AR of the fifth pixel PX5 of the second pixel group PG2.

The active region AR of the first pixel PX1 of the first pixel group PG1 and the active region AR of the second pixel PX2 of the third pixel group PG3 may be integrally formed by being connected to each other through the first connection portion CP1.

The pixel separation structure DTI may be removed from the region corresponding to the first connection portion CP1 between the active region AR of the first pixel PX1 of the first pixel group PG1 and the active region AR of the second pixel PX2 of the third pixel group PG3, and accordingly, the pixel separation structure DTI may have the third open portion OPN3, as shown in FIG. 6, and the first connection portion CP1 may not overlap with the pixel separation structure DTI along the third direction DR3, which is the height direction.

Through the first connection portion CP1 that does not overlap with the pixel separation structure DTI, the active region AR of the first pixel PX1 of the first pixel group PG1 and the active region AR of the second pixel PX2 of the third pixel group PG3 are connected to each other to be integrally formed to be adjacent to the first surface SFA of the substrate 200, and accordingly, the first reset transistor RX1 and the second reset transistor RX2 may be directly connected to each other without an additional wire layer for connection.

The reset transistors RX1 and RX2 may include the first reset transistor RX1 and the second reset transistor RX2 that are directly connected without an additional wire layer, and accordingly, the performance of the reset transistor RX1 and RX2 may be raised without widening the area of the region occupied by the reset transistor RX1 and RX2.

The active region AR of the fourth pixel PX4 of the first pixel group PG1, the active region AR of the third pixel PX3 of the third pixel group PG3, the active region AR of the fifth pixel PX5 of the second pixel group PG2 and the active region AR of the sixth pixel PX6 of the fourth pixel group PG4 may be integrally formed by being connected to each other through the second connection portion CP2.

The pixel separation structure DTI may be removed from the region corresponding to the second connection portion CP2 between the active region AR of the fourth pixel PX4 of the first pixel group PG1, the active region AR of the third pixel PX3 of the third pixel group PG3, the active region AR of the fifth pixel PX5 of the second pixel group PG2 and the active region AR of the sixth pixel PX6 of the fourth pixel group PG4, and accordingly, the pixel separation structure DTI may have the fourth open portion OPN4, as shown in FIG. 6, and the second connection portion CP2 may not overlap with the pixel separation structure DTI along the third direction DR3, which is the height direction.

Through the second connection portion CP2 that does not overlap with the pixel separation structure DTI, the active region AR of the fourth pixel PX4 of the first pixel group PG1, the active region AR of the third pixel PX3 of the third pixel group PG3, the active region AR of the fifth pixel PX5 of the second pixel group PG2 and the active region AR of the sixth pixel PX6 of the fourth pixel group PG4 are connected to each other to be integrally formed to be adjacent to the first surface SFA of the substrate 200, and accordingly, the first source follower transistor S1, the second source follower transistor S2, the third source follower transistor S3, and the fourth source follower transistor S4 may be directly connected to each other without an additional wire layer for connection.

The first source follower transistor S1, the second source follower transistor S2, the third source follower transistor S3 and the fourth source follower transistor S4 of the source follower transistors S1, S2, S3, and S4 may be directly connected without an additional wire layer, and accordingly, unnecessary coupling or resistance due to an additional wire layer may be prevented. In addition, the performance of the source follower transistors S1, S2, S3, and S4 may be raised without widening the area of the region occupied by the source follower transistors S1, S2, S3, and S4.

One of the first gate electrode GE1 located above the active region AR of the seventh pixel PX7 of the second pixel group PG2 and the second gate electrode GE2 located above the active region AR of the eighth pixel PX8 of the second pixel group PG2 may be the selection gate electrode SEL, and the other one may be the dual conversion gate electrode DCG.

The locations of the source follower transistors S1 to S4, the selection transistor SE, the reset transistor RX1 and RX2, and the dual conversion transistor DCX are not limited thereto, and the locations of the source follower transistors S1 to S4, the selection transistor SE, the reset transistor RX1 and RX2, and the dual conversion transistor DCX may be changed in various ways, such that the plurality of pixels PX1, PX2, PX3, PX4, PX5, PX6, PX7, and PX8 may share the source follower transistors S1 to S4, the selection transistor SE, the reset transistor RX1 and RX2, and the dual conversion transistor DCX.

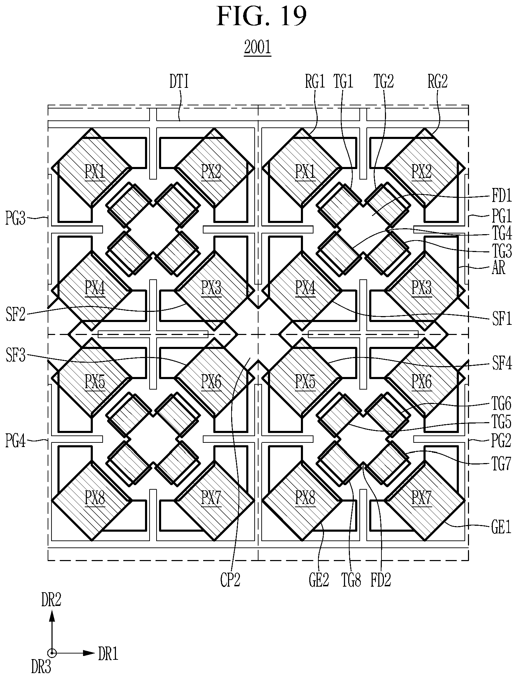

Referring to FIG. 19, an image sensor 2001 according to another embodiment will be described. FIG. 19 is a top plan view of an image sensor according to another embodiment.

Referring to FIG. 19, the image sensor 2001 according to the present embodiment is similar to the image sensor 1002 according to an embodiment shown in FIG. 9 and FIG. 10. Detailed description on the same configuration element is omitted.

The image sensor 2001 according to the present embodiment may further include the third pixel group PG3 and the fourth pixel group PG4 adjacent to the first pixel group PG1 and the second pixel group PG2 along the first direction DR1.

The first reset gate electrode RG1 may be located above the active region AR of the first pixel PX1 of the first pixel group PG1, and the second reset gate electrode RG2 may be located above the active region AR of the second pixel PX2 of the first pixel group PG1.

The first source follower gate electrode SF1 may be located above the active region AR of the fourth pixel PX4 of the first pixel group PG1, the second source follower gate electrode SF2 adjacent to the first pixel group PG1 along the first direction DR1 may be located above the active region AR of the third pixel PX3 of the third pixel group PG3, and the third source follower gate electrode SF3 adjacent to the second pixel group PG2 may be located above the active region AR of the sixth pixel PX6 of the fourth pixel group PG4.

The fourth source follower gate electrode SF4 may be located above the active region AR of the fifth pixel PX5 of the second pixel group PG2.

The first pixel PX1, the second pixel PX2, the third pixel PX3, and the fourth pixel PX4 of the first pixel group PG1 may share the first floating diffusion region FD1.

The first floating diffusion region FD1 may be located in a portion of each of the first pixel PX1, the second pixel PX2, the third pixel PX3, the fourth pixel PX4 of the first pixel group PG1, and the first floating diffusion region FD1 of each of the first pixel PX1, the second pixel PX2, the third pixel PX3, and the fourth pixel PX4 may be integrally formed.

The fifth pixel PX5, the sixth pixel PX6, the seventh pixel PX7, and the eighth pixel PX8 of the second pixel group PG2 may share the second floating diffusion region FD2.

The second floating diffusion region FD2 may be located in a portion of each of the fifth pixel PX5, the sixth pixel PX6, the seventh pixel PX7, the eighth pixel PX8 of the second pixel group PG2, and the second floating diffusion region FD2 of each of the fifth pixel PX5, the sixth pixel PX6, the seventh pixel PX7, the eighth pixel PX8 may be integrally formed.

The active region AR of the fourth pixel PX4 of the first pixel group PG1, the active region AR of the third pixel PX3 of the third pixel group PG3 configured to absorb and detect light of a color different from the first pixel group PG1, the active region AR of the fifth pixel PX5 of the second pixel group PG2 configured to absorb and detect light of a color different from the first pixel group PG1 and the active region AR of the sixth pixel PX6 of the fourth pixel group PG4 that absorbs and detects light of a color different from the second pixel group PG2 may be integrally formed to be connected to each other through the second connection portion CP2 that does not overlap with the pixel separation structure DTI, and accordingly, the first source follower transistor S1, the second source follower transistor S2, the third source follower transistor S3, and a fourth source follower transistor S4 may be directly connected without relying on the plurality of vias ML1 and the plurality of wire layers ML2 and ML3 of the first structure 300.

The source follower transistors S1, S2, S3, and S4 of the image sensor 2001 according to an embodiment may include the first source follower transistor S1, the second source follower transistor S2, the third source follower transistor S3 and the fourth source follower transistor S4 that are directly connected without an additional wire layer.

The first source follower transistor S1, the second source follower transistor S2, the third source follower transistor S3 and the fourth source follower transistor S4 of the source follower transistors S1, S2, S3, and S4 may be directly connected without an additional wire layer, and accordingly, unnecessary coupling or resistance due to an additional wire layer may be prevented. In addition, the performance of the source follower transistors S1, S2, S3, and S4 may be raised without widening the area of the region occupied by the source follower transistors S1, S2, S3, and S4.

Unlike the image sensor 2000 according to an embodiment shown in FIG. 18, the first reset gate electrode RG1 and the second reset gate electrode RG2 of the image sensor 2001 according to the present embodiment may be located above the active regions AR of the first pixel PX1 and the second pixel PX2 of the first pixel group PG1, and the first reset transistor RX1 and the second reset transistor RX2 may not be directly connected but connected by an additional wire layer.

Various features of the image sensors according to embodiments described above are all applicable to image sensor according to the present embodiment.

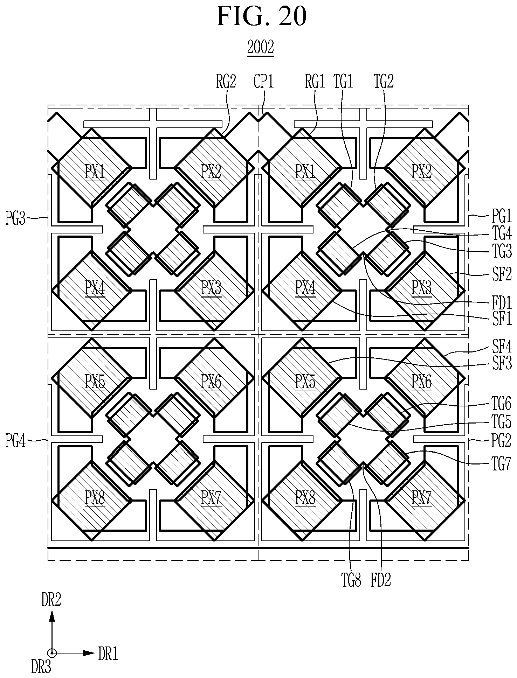

Referring to FIG. 20, an image sensor 2002 according to another embodiment will be described. FIG. 20 is a top plan view of an image sensor according to another embodiment.

Referring to FIG. 20, the image sensor 2002 according to the present embodiment is similar to the image sensor 1003 according to an embodiment shown in FIG. 11 and FIG. 12. Detailed description on the same configuration element is omitted.

The image sensor 2002 according to the present embodiment may further include the third pixel group PG3 and the fourth pixel group PG4 adjacent to the first pixel group PG1 and the second pixel group PG2 along the first direction DR1.

The first reset gate electrode RG1 may be located above the active region AR of the first pixel PX1 of the first pixel group PG1, adjacent to the first pixel group PG1 along the first direction DR1, and the second reset gate electrode RG2 configured to absorb and detect light of a color different from the first pixel group PG1 may be located above the active region AR of the second pixel PX2 of the third pixel group PG3.

The first source follower gate electrode SF1 may be located above the active region AR of the fourth pixel PX4 of the first pixel group PG1, and the second source follower gate electrode SF2 may be located above the active region AR of the third pixel PX3 of the first pixel group PG1.

The third source follower gate electrode SF3 may be located above the active region AR of the fifth pixel PX5 of the second pixel group PG2, and the fourth source follower gate electrode SF4 may be located above the active region AR of the sixth pixel PX6 of the second pixel group PG2.

One of the first gate electrode GE1 located above the active region AR of the seventh pixel PX7 of the second pixel group PG2 and the second gate electrode GE2 located above the active region AR of the eighth pixel PX8 of the second pixel group PG2 may be the selection gate electrode SEL, and the other one may be the dual conversion gate electrode DCG.

The first pixel PX1, the second pixel PX2, the third pixel PX3, and the fourth pixel PX4 of the first pixel group PG1 may share the first floating diffusion region FD1.

The first floating diffusion region FD1 may be located in a portion of each of the first pixel PX1, the second pixel PX2, the third pixel PX3, the fourth pixel PX4 of the first pixel group PG1, and the first floating diffusion region FD1 of each of the first pixel PX1, the second pixel PX2, the third pixel PX3, and the fourth pixel PX4 may be integrally formed.

The fifth pixel PX5, the sixth pixel PX6, the seventh pixel PX7, and the eighth pixel PX8 of the second pixel group PG2 may share the second floating diffusion region FD2.

The second floating diffusion region FD2 may be located in a portion of each of the fifth pixel PX5, the sixth pixel PX6, the seventh pixel PX7, the eighth pixel PX8 of the second pixel group PG2, and the second floating diffusion region FD2 of each of the fifth pixel PX5, the sixth pixel PX6, the seventh pixel PX7, the eighth pixel PX8 may be integrally formed.

The active region AR of the first pixel PX1 of the first pixel group PG1 and the active region AR of the second pixel PX2 of the third pixel group PG3 may be integrally formed by being connected to each other through the first connection portion CP1. The first connection portion CP1 between the active region AR of the first pixel PX1 of the first pixel group PG1 and the active region AR of the second pixel PX2 of the third pixel group PG3 may not overlap with the pixel separation structure DTI along the third direction DR3, which is the height direction.

The active region AR of the third pixel PX3 of the first pixel group PG1, the active region AR of the fourth pixel PX4 of the first pixel group PG1, the active region AR of the fifth pixel PX5 of the second pixel group PG2 and the active region AR of the sixth pixel PX6 of the second pixel group PG2 may not be directly connected to each other, but may be connected through an additional wire layer.

Various features of the image sensors according to embodiments described above are all applicable to image sensor according to the present embodiment.

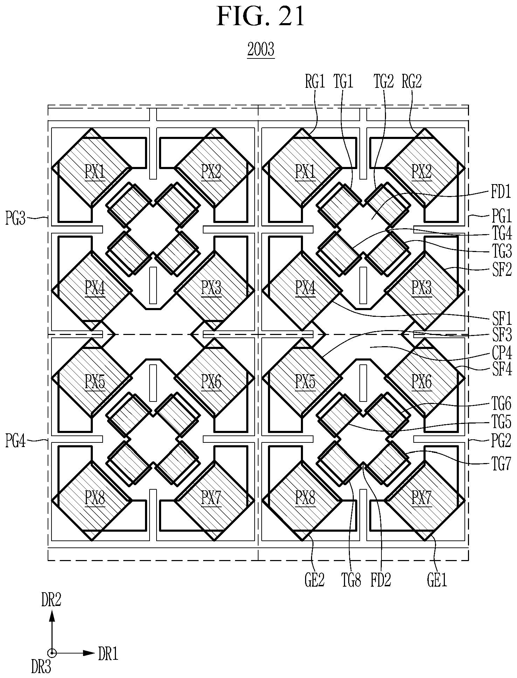

Referring to FIG. 21, an image sensor 2003 according to another embodiment will be described. FIG. 21 is a top plan view of an image sensor according to another embodiment.

Referring to FIG. 21, the image sensor 2003 according to the present embodiment is similar to the image sensor 1004 according to an embodiment shown in FIG. 13 and FIG. 14. Detailed description on the same configuration elements is omitted.

The image sensor 2003 according to the present embodiment may further include the third pixel group PG3 and the fourth pixel group PG4 adjacent to the first pixel group PG1 and the second pixel group PG2 along the first direction DR1.

The first reset gate electrode RG1 may be located above the active region AR of the first pixel PX1 of the first pixel group PG1, and the second reset gate electrode RG2 may be located above the active region AR of the second pixel PX2 of the first pixel group PG1.

The first source follower gate electrode SF1 may be located above the active region AR of the fourth pixel PX4 of the first pixel group PG1, and the second source follower gate electrode SF2 may be located above the active region AR of the third pixel PX3 of the first pixel group PG1.

The third source follower gate electrode SF3 may be located above the active region AR of the fifth pixel PX5 of the second pixel group PG2, and the fourth source follower gate electrode SF4 may be located above the active region AR of the sixth pixel PX6 of the second pixel group PG2.

One of the first gate electrode GE1 located above the active region AR of the seventh pixel PX7 of the second pixel group PG2 and the second gate electrode GE2 located above the active region AR of the eighth pixel PX8 of the second pixel group PG2 may be the selection gate electrode SEL, and the other one may be the dual conversion gate electrode DCG.

The first pixel PX1, the second pixel PX2, the third pixel PX3, and the fourth pixel PX4 of the first pixel group PG1 may share the first floating diffusion region FD1.

The first floating diffusion region FD1 may be located in a portion of each of the first pixel PX1, the second pixel PX2, the third pixel PX3, the fourth pixel PX4 of the first pixel group PG1, and the first floating diffusion region FD1 of each of the first pixel PX1, the second pixel PX2, the third pixel PX3, and the fourth pixel PX4 may be integrally formed.

The fifth pixel PX5, the sixth pixel PX6, the seventh pixel PX7, and the eighth pixel PX8 of the second pixel group PG2 may share the second floating diffusion region FD2.

The second floating diffusion region FD2 may be located in a portion of each of the fifth pixel PX5, the sixth pixel PX6, the seventh pixel PX7, the eighth pixel PX8 of the second pixel group PG2, and the second floating diffusion region FD2 of each of the fifth pixel PX5, the sixth pixel PX6, the seventh pixel PX7, the eighth pixel PX8 may be integrally formed.

The active region AR of the third pixel PX3 of the first pixel group PG1, the active region AR of the fourth pixel PX4 of the first pixel group PG1, the active region AR of the fifth pixel PX5 of the second pixel group PG2 and the active region AR of the sixth pixel PX6 of the second pixel group PG2 that absorbs and detects light of a color different from the first pixel group PG1 may be integrally formed by being connected to each other through the fourth connection portion CP4, and accordingly, the first source follower transistor S1, the second source follower transistor S2, the third source follower transistor S3, and the fourth source follower transistor S4 may be directly connected without relying on an additional wire.

The source follower transistors S1, S2, S3, and S4 of the image sensor 2003 according to an embodiment may include the first source follower transistor S1, the second source follower transistor S2, the third source follower transistor S3 and the fourth source follower transistor S4 that are directly connected without an additional wire layer.

The first source follower transistor S1, the second source follower transistor S2, the third source follower transistor S3 and the fourth source follower transistor S4 of the source follower transistors S1, S2, S3, and S4 may be directly connected without an additional wire layer, and accordingly, unnecessary coupling or resistance due to an additional wire layer may be prevented. In addition, the performance of the source follower transistors S1, S2, S3, and S4 may be raised without widening the area of the region occupied by the source follower transistors S1, S2, S3, and S4.

The first reset gate electrode RG1 and the second reset gate electrode RG2 of the image sensor 2003 according to the present embodiment may be located above the active regions AR of the first pixel PX1 and the second pixel PX2 of the first pixel group PG1, and the first reset transistor RX1 and the second reset transistor RX2 may not be directly connected.

Various features of the image sensors according to embodiments described above are all applicable to image sensor according to the present embodiment.

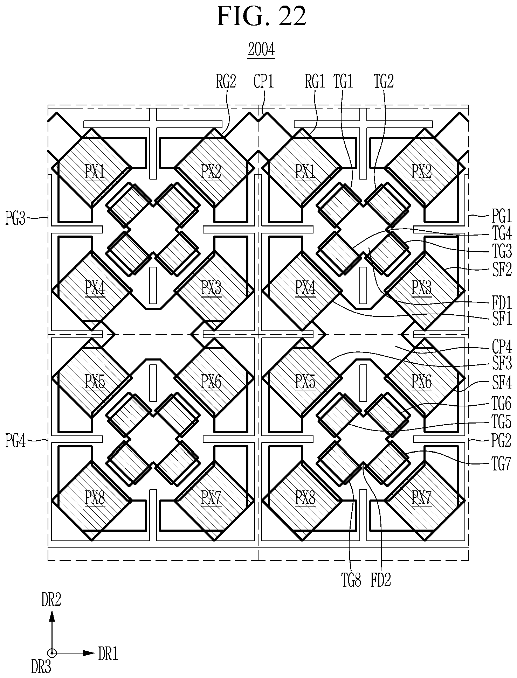

Referring to FIG. 22, an image sensor 2004 according to another embodiment will be described. FIG. 22 is a top plan view of an image sensor according to another embodiment.

Referring to FIG. 22, the image sensor 2004 according to the present embodiment is similar to the image sensor 1005 according to an embodiment shown in FIG. 15 and FIG. 16. Detailed description on the same configuration element is omitted.

The image sensor 2004 according to the present embodiment may further include the third pixel group PG3 and the fourth pixel group PG4 adjacent to the first pixel group PG1 and the second pixel group PG2 along the first direction DR1.

The first reset gate electrode RG1 may be located above the active region AR of the first pixel PX1 of the first pixel group PG1, adjacent to the first pixel group PG1 along the first direction DR1, and the second reset gate electrode RG2 configured to absorb and detect light of a color different from the first pixel group PG1 may be located above the active region AR of the second pixel PX2 of the third pixel group PG3.

The first source follower gate electrode SF1 may be located above the active region AR of the fourth pixel PX4 of the first pixel group PG1, and the second source follower gate electrode SF2 may be located above the active region AR of the third pixel PX3 of the first pixel group PG1.

The third source follower gate electrode SF3 may be located above the active region AR of the fifth pixel PX5 of the second pixel group PG2, and the fourth source follower gate electrode SF4 may be located above the active region AR of the sixth pixel PX6 of the second pixel group PG2.

One of the first gate electrode GE1 located above the active region AR of the seventh pixel PX7 of the second pixel group PG2 and the second gate electrode GE2 located above the active region AR of the eighth pixel PX8 of the second pixel group PG2 may be the selection gate electrode SEL, and the other one may be the dual conversion gate electrode DCG.

The first pixel PX1, the second pixel PX2, the third pixel PX3, and the fourth pixel PX4 of the first pixel group PG1 may share the first floating diffusion region FD1.

The first floating diffusion region FD1 may be located in a portion of each of the first pixel PX1, the second pixel PX2, the third pixel PX3, the fourth pixel PX4 of the first pixel group PG1, and the first floating diffusion region FD1 of each of the first pixel PX1, the second pixel PX2, the third pixel PX3, and the fourth pixel PX4 may be integrally formed.

The fifth pixel PX5, the sixth pixel PX6, the seventh pixel PX7, and the eighth pixel PX8 of the second pixel group PG2 may share the second floating diffusion region FD2.

The second floating diffusion region FD2 may be located in a portion of each of the fifth pixel PX5, the sixth pixel PX6, the seventh pixel PX7, the eighth pixel PX8 of the second pixel group PG2, and the second floating diffusion region FD2 of each of the fifth pixel PX5, the sixth pixel PX6, the seventh pixel PX7, the eighth pixel PX8 may be integrally formed.

The active region AR of the first pixel PX1 of the first pixel group PG1 and the active region AR of the second pixel PX2 of the third pixel group PG3 may be integrally formed by being connected to each other through the first connection portion CP1. The first connection portion CP1 between the active region AR of the first pixel PX1 of the first pixel group PG1 and the active region AR of the second pixel PX2 of the third pixel group PG3 may not overlap with the pixel separation structure DTI along the third direction DR3, which is the height direction.

The active region AR of the third pixel PX3 of the first pixel group PG1, the active region AR of the fourth pixel PX4 of the first pixel group PG1, the active region AR of the fifth pixel PX5 of the second pixel group PG2 configured to absorb and detect light of a color different from the first pixel group PG1, and the active region AR of the sixth pixel PX6 of the second pixel group PG2 may be integrally formed by being connected to each other through the fourth connection portion CP4.

The fourth connection portion CP4 between the active region AR of the third pixel PX3 of the first pixel group PG1, the active region AR of the fourth pixel PX4 of the first pixel group PG1, the active region AR of the fifth pixel PX5 of the second pixel group PG2, and the active region AR of the sixth pixel PX6 of the second pixel group PG2 may not overlap with the pixel separation structure DTI along the third direction DR3, which is the height direction.

The active region AR of the first pixel PX1 of the first pixel group PG1 and the active region AR of the second pixel PX2 of the third pixel group PG3 that absorbs and detects light of a color different from the first pixel group PG1 may be integrally formed by being connected to each other through the first connection portion CP1, and accordingly, the first reset transistor RX1 and the second reset transistor RX2 may be directly connected without relying on the plurality of vias ML1 and the plurality of wire layers ML2 and ML3 of the first structure 300.

The active region AR of the third pixel PX3 of the first pixel group PG1, the active region AR of the fourth pixel PX4 of the first pixel group PG1, the active region AR of the fifth pixel PX5 of the second pixel group PG2 and the active region AR of the sixth pixel PX6 of the second pixel group PG2 that absorbs and detects light of a color different from the first pixel group PG1 may be integrally formed by being connected to each other through the fourth connection portion CP4, and accordingly, the first source follower transistor S1, the second source follower transistor S2, the third source follower transistor S3, and the fourth source follower transistor S4 may be directly connected without relying on an additional wire.

The reset transistor RX1 and RX2 may include the first reset transistor RX1 and the second reset transistor RX2 that are directly connected without an additional wire layer, and accordingly, the performance of the reset transistor RX1 and RX2 may be raised without widening the area of the region occupied by the reset transistor RX1 and RX2.

The source follower transistors S1, S2, S3, and S4 may include the first source follower transistor S1, the second source follower transistor S2, the third source follower transistor S3 and the fourth source follower transistor S4 that are directly connected without an additional wire layer.

The first source follower transistor S1, the second source follower transistor S2, the third source follower transistor S3 and the fourth source follower transistor S4 of the source follower transistors S1, S2, S3, and S4 may be directly connected without an additional wire layer, and accordingly, unnecessary coupling or resistance due to an additional wire layer may be prevented. In addition, the performance of the source follower transistors S1, S2, S3, and S4 may be raised without widening the area of the region occupied by the source follower transistors S1, S2, S3, and S4.

Various features of the image sensors according to embodiments described above are all applicable to image sensor according to the present embodiment.

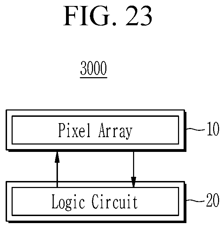

Referring to FIG. 23, a stacking structure of an image sensor 3000 according to an embodiment will be described briefly. FIG. 23 shows a schematic stacking structure of an image sensor according to another embodiment.

Referring to FIG. 23, the image sensor 3000 according to some embodiments may include a first semiconductor chip 10 and a second semiconductor chip 20. The first semiconductor chip 10 and the second semiconductor chip 20 may overlap with each other along the height direction. The first semiconductor chip 10 and the second semiconductor chip 20 may stacked in a vertical direction.

The photoelectric conversion layers PD1 to PD8 of the image sensors according to embodiments described above, the transmission transistors T1 to T8, the reset transistor RX1 and RX2, the source follower transistors S1 to S4, the selection transistor SE and the dual conversion transistor DCX may be formed in the first semiconductor chip 10.

The second semiconductor chip 20 may include the logic circuit of FIG. 1.

Although not shown in the drawings, an image sensor according to another embodiment may further include a memory cell array in the second semiconductor chip 20. The memory cell array may store data based on digital signals.

Various features of the image sensors according to embodiments described above are all applicable to a stacking structure of an image sensor according to the present embodiment.

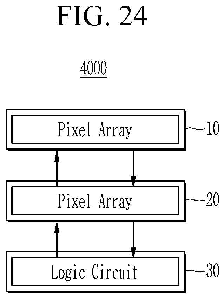

Referring to FIG. 24, a stacking structure of an image sensor 4000 according to an embodiment will be described briefly. FIG. 24 shows a schematic stacking structure of an image sensor according to another embodiment.

Referring to FIG. 24, the image sensor 4000 according to some embodiments may include the first semiconductor chip 10, the second semiconductor chip 20 and a third semiconductor chip 30. The first semiconductor chip 10, the second semiconductor chip 20 and the third semiconductor chip 30 may overlap with each other along the height direction. The first semiconductor chip 10, the second semiconductor chip 20 and the third semiconductor chip 30 may be sequentially stacked in the vertical direction. The first semiconductor chip 10 may be an upper plate, the second semiconductor chip 20 may be a middle plate, and the third semiconductor chip 30 may be a lower plate.

The photoelectric conversion regions PD1 to PD8 and the transmission transistors T1 to T8 of the image sensors according to embodiments described above may be formed in the first semiconductor chip 10, and the reset transistor RX1 and RX2, the dual conversion transistor DCX, the source follower transistors S1 to S4, and the selection transistor SE may be formed in the second semiconductor chip 20.

The third semiconductor chip 30 may include the logic circuit of FIG. 1.

Contrarily, the first semiconductor chip 10 and the second semiconductor chip 20 may be formed in one chip.

The first semiconductor chip 10 and the second semiconductor chip 20 may include a pixel array, respectively, and may be a 3-stack image sensor formed and staked in different chips.

Various features of the image sensors according to embodiments described above are all applicable to a stacking structure of an image sensor according to the present embodiment.

While this disclosure has been described in connection with what is presently considered to be practical embodiments, it is to be understood that the disclosure is not limited to the disclosed embodiments, but, on the contrary, is intended to cover various modifications and equivalent arrangements included within the spirit and scope of the appended claims.

## Claims

1. An image sensor (1000-1005, 2000-2004), comprising:
a first pixel (PX1-PX8) configured to detect a first color;
a second pixel (PX1-PX8) configured to detect a second color different from the first color;
a first active region (AR) located in the first pixel (PX1-PX8); and
a second active region (AR) located in the second pixel (PX1-PX8),
wherein the first active region (AR) and the second active region (AR) are directly connected to each other.

2. The image sensor (1000-1005, 2000-2004) of claim 1, further comprising a pixel separation structure (DTI) located between the first pixel (PX1-PX8) and the second pixel (PX1-PX8), and located within a substrate (200), wherein:
the first active region (AR) and the second active region (AR) are connected to each other through a connection portion (CP1-CP4); and
none of the first active region (AR), the second active region (AR), or the connection portion (CP1-CP4) overlap with the pixel separation structure (DTI) along a height direction (DR3).

3. The image sensor (1000-1005, 2000-2004) of claim 2, wherein:
the substrate (200) comprises a first surface (SFA) and a second surface (SFB) opposite each other;
the pixel separation structure (DTI) penetrates the substrate (200) from the first surface (SFA) to the second surface (SFB); and
the first active region (AR), the second active region (AR), and the connection portion (CP1-CP4) are located adjacent to the first surface (SFA) of the substrate (200).

4. The image sensor (1000-1005, 2000-2004) of claim 2 or 3, further comprising:
a first gate electrode located above the first active region (AR); and
a second gate electrode located above the second active region (AR),
wherein the first gate electrode is a first source follower gate electrode (SF1-SF4), and
wherein the second gate electrode is a second source follower gate electrode (SF1-SF4).

5. The image sensor (1000-1002, 2000, 2001) of claim 4, further comprising:
a third pixel (PX1-PX8) disposed adjacent to the first pixel (PX1-PX8) along a first direction (DR1), and configured to detect a color different from the first color;
a fourth pixel (PX1-PX8) disposed adjacent to the second pixel (PX1-PX8) along the first direction (DR1), and configured to detect a color different from the second color;
a third active region (AR) located in the third pixel (PX1-PX8); and
a fourth active region (AR) located in the fourth pixel (PX1-PX8),
wherein the first active region (AR) and the second active region (AR) are directly interconnected to the third active region (AR) and the fourth active region (AR).

6. The image sensor (1000-1002, 2000, 2001) of claim 5, further comprising:
a third gate electrode located above the third active region (AR); and
a fourth gate electrode located above the fourth active region (AR),
wherein one of the third gate electrode and the fourth gate electrode is a third source follower gate electrode (SF1-SF4).

7. The image sensor (1000-1002) of claim 6, wherein a remaining one of the third gate electrode and the fourth gate electrode is a selection gate electrode (SEL).

8. The image sensor (2000, 2001) of claim 6, wherein a remaining one of the third gate electrode and the fourth gate electrode is a fourth source follower gate electrode (SF1-SF4).

9. The image sensor (1004, 1005, 2003, 2004) of claim 4, further comprising:
a third pixel (PX1-PX8) disposed adjacent to the first pixel (PX1-PX8) along a first direction (DR1), and configured to detect the first color;
a fourth pixel (PX1-PX8) disposed adjacent to the second pixel (PX1-PX8) along the first direction (DR1), and configured to detect the second color;
a third active region (AR) located in the third pixel (PX1-PX8); and
a fourth active region (AR) located in the fourth pixel (PX1-PX8),
wherein the first active region (AR) and the second active region (AR) are directly interconnected to the third active region (AR) and the fourth active region (AR).

10. The image sensor (1004, 1005, 2003, 2004) of claim 9, further comprising:
a third gate electrode located above the third active region (AR); and
a fourth gate electrode located above the fourth active region (AR),
wherein one of the third gate electrode and the fourth gate electrode is a third source follower gate electrode (SF1-SF4).

11. The image sensor (1004, 1005) of claim 10, wherein:
a remaining one of the third gate electrode and the fourth gate electrode is a selection gate electrode (SEL).

12. The image sensor (2003, 2004) of claim 10, wherein:
a remaining one of the third gate electrode and the fourth gate electrode is a fourth source follower gate electrode (SF1-SF4).

13. An image sensor (1000-1005, 2000-2004) according to claim 1, comprising:
a first pixel group (PG1-PG4) configured to detect the first color, and comprising a plurality of pixels (PX1-PX8) comprising the first pixel (PX1-PX8); and
a second pixel group (PG1-PG4) configured to detect the second color different from the first color, and comprising a plurality of pixels (PX1-PX8) comprising the second pixel (PX1-PX8) adjacent to the first pixel group (PG1-PG4),
wherein the first pixel group (PG1-PG4) and the second pixel group (PG1-PG4) share a reset transistor, a source follower transistor (S1-S4), and a selection transistor (SE);
wherein the source follower transistor (S1-S4) comprises a first source follower transistor (S1-S4) located in the first pixel (PX1-PX8) and a second source follower transistor (S1-S4) located in the second pixel (PX1-PX8); and
wherein the first source follower transistor (S1-S4) comprises the first active region (AR) and the second source follower transistor (S1-S4) comprises the second active region (AR) so that the first source follower transistor (S1-S4) is directly connected to the second source follower transistor (S1-S4).

14. The image sensor (1000-1002, 2000, 2001) of claim 13, further comprising:
a third pixel group (PG1-PG4) disposed adjacent to the first pixel group (PG1-PG4) along a first direction (DR1), configured to detect a color different from the first color, and comprising a plurality of pixels (PX1-PX8) comprising a third pixel (PX1-PX8); and
a fourth pixel group (PG1-PG4) disposed adjacent to the second pixel group (PG1-PG4) along the first direction (DR1), configured to detect a color different from the second color, and comprising a plurality of pixels (PX1-PX8) comprising a fourth pixel (PX1-PX8),
wherein the source follower transistor (S1-S4) further comprises a third source follower transistor (S1-S4) located in the third pixel (PX1-PX8), and
wherein the third source follower transistor (S1-S4) is directly connected to the first source follower transistor (S1-S4), and the second source follower transistor (S1-S4).

15. The image sensor (2000, 2001) of claim 14, wherein:
the selection transistor (SE) is located in the fourth pixel (PX1-PX8); and
the source follower transistor (S1-S4) is directly connected to the selection transistor (SE).
